(19) Europäisches Patentamt
European Patent Office
Office européen des brevets

(11) **EP 4 641 959 A1**

(12) **EUROPEAN PATENT APPLICATION**
published in accordance with Art. 153(4) EPC

(43) Date of publication:
**29.10.2025 Bulletin 2025/44**

(21) Application number: **23916463.5**

(22) Date of filing: **28.12.2023**

(51) International Patent Classification (IPC):
**H04L 1/00** (2006.01)   **H03M 13/13** (2006.01)
**H03M 13/00** (2006.01)

(52) Cooperative Patent Classification (CPC):
**H03M 13/00; H03M 13/13; H04L 1/00**

(86) International application number:
**PCT/KR2023/021953**

(87) International publication number:
**WO 2024/150980 (18.07.2024 Gazette 2024/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.01.2023 KR 20230005763**
**06.02.2023 KR 20230015853**

(71) Applicant: **Samsung Electronics Co., Ltd.
Suwon-si, Gyeonggi-do 16677 (KR)**

(72) Inventors:
• **JANG, Min
Suwon-si, Gyeonggi-do 16677 (KR)**
• **KIM, Kyeongyeon
Suwon-si, Gyeonggi-do 16677 (KR)**
• **SHIN, Heon
Suwon-si, Gyeonggi-do 16677 (KR)**

(74) Representative: **HGF
HGF Limited
1 City Walk
Leeds LS11 9DX (GB)**

(54) **METHOD AND DEVICE FOR TESTING VALIDITY OF RECEPTION SIGNAL IN COMMUNICATION SYSTEM AND BROADCAST SYSTEM**

(57)     Provided is a device in a communication system or a broadcast system. The device may comprise a memory, at least one transceiver, and at least one processor connected to the memory and the at least one transceiver. The device may be configured to: acquire a signal; identify information about at least one dummy parity check (PC) bit among one or more PC bits of the signal on the basis of at least one information bit of the signal and a rate matching size for a polar code; identify a decoder setting for error detection and error correction on the basis of information about the at least one dummy PC bit; and decode the signal on the basis of the decoder setting. The at least one dummy PC bit may include a bit having a fixed value regardless of one or more preceding bits of the decoding among the one or more PC bits.

FIG. 7

**Description**

**[Technical Field]**

Various embodiments of the present disclosure relate to a communication system and a broadcasting system. For example, the present disclosure relates to a method and a device for testing validity of a reception signal in a communication system and a broadcasting system.

**[Background Art]**

In a general communication system and a broadcasting system, a scenario in which a receiver such as a base station and a portable terminal receives data may be largely divided into three according to a characteristic of a signal.

A first scenario is a scenario in which a transmitter transmits an intended signal according to a normal setting. This situation is referred to as normal transmission (TX), and the receiver should accurately decode information transmitted from the signal.

A second scenario is a scenario in which the transmitter transmits a signal different from the pre-set. This situation may occur when there is a problem with prior communication between transceivers. Due to an error or inaccuracy that may be caused by various causes, the transmitter may generate and transmit a signal based on incorrect scheduling information (a signal configuration, information, communication resources used, and the like) or setting information. Since a setting of the transmitted signal is different from a setting in which the receiver expects, the receiver processes the received signal as a normal signal, but the signal actually obtained through the processing may be a kind of random signal. A corresponding situation may be referred to as random transmission (RTX). In this case, the receiver should be aware of the situation and avoid determining that a final processing and a decoded result are normal.

A third scenario is a scenario in which the transmitter does not transmit a signal, and the receiver receives noise and interference. This situation may occur when there is a problem with prior communication between transceivers. In an example, the transmitter may not transmit any signal because it does not receive information on scheduling from the prior communication. The receiver may expect the transmitter to transmit the signal. The receiver may determine background noise and the received interference as the received signal. The receiver may process the background noise and the interference. This situation may be referred to as discontinuous transmission (DTX). Like an RTX situation, in this case, the receiver should accurately recognize a corresponding situation and avoid determining that a decoded result is normal.

In summary, the receiver may accurately distinguish different situations for the signal transmission and perform an operation suitable for a situation. For example, in a case of receiving a normally intended signal (TX), the receiver should correctly decode information transmitted from the received signal. For example, in a case that the receiver receives a random signal (RTX) or in a case that only noise and interference (DTX) is received, due to an incorrect setting and various causes, the receiver should accurately recognize the corresponding situation and perform an appropriate follow-up operation. A prior probability of each situation may be statistically identified or estimated.

In a process of distinguishing different situations, error detection codes and error correction codes (ECC) used in TX situations may be effectively utilized. In the general communication system and the broadcasting system, an error may occur due to noise, interference, and the like, on a communication channel between the transmitter and the receiver. In this way, in order to identify and process the error generated by the communication channel at the receiver, the transmitter encodes a bit sequence to be transmitted with the error detection codes and the error correction codes. In particular, the error correction codes are referred to as a channel coding technique or a forward error correction (FEC) technique.

An encoding process of the error detection codes and the error correction codes may include a process of generating a codeword bit sequence based on an information bit sequence to be transmitted. A normal codeword bit sequence may satisfy constraints by the used error detection and correction codes. A decoder of the receiver may detect whether there is an error in the received signal based on information on the constraint or correct the error. Therefore, the receiver may determine whether the reception signal satisfies the constraints of the used error detection and correction codes, based on observations such as the reception signal, a log likelihood ratio (LLR) sequence, a bit sequence, and the like. Accordingly, validity of the received signal may be effectively determined.

The error detection codes are used to detect whether a bit error exists in a target bit sequence. The most commonly used code is a cyclic redundancy check (CRC) code.

The error correction codes are used to self-correct the bit error in a case that the bit error is included in the target bit sequence. Ideally, the receiver may correct the error in a way of finding a codeword bit sequence with a high probability of being transmitted based on the observation and obtaining an information bit sequence transmitted from the codeword bit sequence. For example, the error correction codes may include a convolutional code, a turbo code, a low-density parity-check coding (LDPC code), or a polar code. In the present disclosure, the polar code is illustrated as an error correction code. In the present disclosure, operations of the transmitter and the receiver are described in the communication system and the broadcasting system using the polar code.

A reference described in the present disclosure is as follows.

[1]E. Arikan, "Channel Polarization: a method for constructing capacity-achieving codes for symmetric binary-input memoryless channels," IEEE Trans. Information Theory, vol. 55, no. 7, pp. 3051-3073, 2009.

[2]I. Tal and A. Vardy, "List decoding of polar codes," IEEE Trans. Inf. Theory, vol. 61, no. 5, pp. 2213-2226, 2015.

[3]3GPP, NR multiplexing and channel coding (Release 15), TSG RAN TS38.212 v15.0.1, Feb. 2017.

[4]A. Balatsoukas-Stimming, M. B. Parizi, and A. Burg, "LLR-based successive cancellation list decoding for polar codes,"IEEE Trans. Sig. Processing, no. 63, vol. 19, pp. 5165-5179, Oct. 2015.

[5]M. Jang, H. Lim, and H. Jeong, "Device and method to transmit and receive signal in communication system,"US Patent U.S. 11,398,838, Issued Jul. 2022.

[6]M. Jang, J. Lee, S.-H. Kim, and K. Yang, "Improving the tradeoff between error correction and detection of concatenated polar codes," IEEE Trans. Commun., vol. 69, no.7, pp. 4254-4266, Jul. 2021.

[7]M. Jang and H. Lim, "Method and apparatus for decoding polar code in communication and broadcasting system," US Patent U.S. 17,749,854, Filed Sept. 2022.

The polar code is a channel code that achieves point-to-point channel capacity in a binary discrete memoryless channel (B-DMC) using a phenomenon called channel polarization [1]. A process of encoding the polar code is defined by a generator matrix recursively configured from a polarization kernel of a size 2x2. A process of decoding the polar code is performed in a successive cancellation (SC) method, and is characterized by sequentially estimating encoding input bits one by one.

By the encoding and decoding process of the polar code, channels for multiple bits are combined and then separated, and through the combination and the separation, it may be analyzed that an end-to-end channel for each bit is transformed into a polarized sub-channel. Some sub-channels become excellent channels with large channel capacities, while others become poor channels with small channel capacities. A total sum of the channel capacities of the sub-channels remains the same before and after the change. As a code length increases, a degree of the channel polarization increases. The excellent channel has a maximum channel capacity of 1, which is the maximum channel capacity that a binary channel may have, and the poor channel has a channel capacity of 0. Based on the channel polarization, the transmitter may transmit the information bit to be transmitted to the excellent channel. Based on the channel polarization, the receiver may allocate a frozen bit having no amount of information to the poor channel. Through the channel polarization, the total sum of the channel capacities may be effectively increased.

The SC decoding method for the polar code may be extended to SC-list (SCL) decoding, SC-stack (SCS) decoding, SC-flip (SCF) decoding, and the like, in order to achieve better performance. Among them, the SCL decoding[2] is known as the most widely used decoding method for the polar code. An SCL decoding algorithm achieves excellent error correction performance by maintaining a plurality of candidate groups rather than one in the sequential bit estimation process. In addition, validity of a candidate group obtained during or after the SCL decoding operation may be identified by outer coding such as a CRC code and a parity-check (PC) code, and the like. The performance may be further improved due to the outer coding. Due to the method, the polar code shows better performance when transmitting bits of a short length compared to other error correction codes. Due to its excellent performance, in a 3rd generation partnership project (3GPP) new radio (NR), which is a 5th generation (5G) communication standard, uses the polar code when transmitting control information of a short length.

**[Disclosure]**

**[Technical Problem]**

Embodiments of the present disclosure are intended to accurately distinguish transmission scenarios in a communication system and a broadcasting system. In the communication system and the broadcasting system, a receiver may experience a situation in which an intended signal is received (e.g., a transmission (TX) scenario), a state in which an unintended random-like signal (e.g., a random transmission (RTX) scenario) is received, and a situation in which only noise and interference are received (e.g., a discontinuous transmission (DTX) scenario). In a case that the intended signal is received (e.g., the TX scenario), the receiver should accurately decode information transmitted therefrom. In a case that it is not (e.g., the RTX scenario, the DTX scenario), the receiver should accurately recognize that the signal is not valid and perform an appropriate follow-up operation. Accurate determination and operation for the transmission situation should be accompanied for a normal communication environment.

According to embodiments of the present disclosure, a polar code may be used in the transmission scenarios. A problem of determining validity of the signal may be solved by solving a problem of detecting an error in a polar code system. A valid signal or codeword bit sequence in a channel code system is defined by a channel code used and its shape is limited. That is, it may be determined that a signal or bit sequence that greatly deviates from a constraint given by the channel code or greatly violates the constraint is not the valid signal. Therefore, determining the validity of the signal is greatly affected by error detection performance of the used channel code system. In the present disclosure, decoding operations are designed and defined to effectively determine the validity of the reception signal in consideration of a characteristic of outer coding concatenated with the polar code.

An embodiment of the present disclosure relates to a method and a device for operating a decoder of the polar code for determining validity of an effective signal in a new radio (NR) system, which is a 5th generation (5G) communication standard. In the 5G NR system, the polar code is concatenated and used with two types of outer codes, which are a cyclic redundancy check (CRC) code and a parity-check (PC) code, to simultaneously achieve an appropriate level of error detection and correction performance. The CRC code is used for error detection with respect to a candidate group codeword obtained after SCL decoding, and the PC code is used to correct the error in the candidate group codeword obtained during the SCL decoding.

Referring to the previous documents [5] and [6], an operation method and a device of the SCL decoder that flexibly controls error detection and correction performance based on characteristics of two concatenated outer codes used in the 5G NR polar code system are described. Specifically, a technique according to the documents [5] and [6] converts some or all of parity bits of the PC code designed to be used for error correction, for error detection. Additionally, the technique flexibly adjusts error detection performance by controlling the number of candidate groups that may finally perform error detection by the CRC code in the SCL decoder. In summary, the technique achieves desired validity determination performance by appropriately determining a combination of the number of PC bits to be used for error detection and the number of CRC decoding attempts after the SCL decoding.

The present disclosure relates to a method and a device for more accurately achieving targeted validity determination performance by additionally considering a dummy parity bit that occurs unintentionally in the 5G NR polar code system. The dummy parity bit means a parity bit that is classified and generated as a parity bit by a concatenation code, but does not function due to a code configuration. In the polar code generated by the 5G NR system, the dummy parity bit may be generated up to 3 bits according to a code dimension and a code length. The code dimension indicates an input bit sequence length of encoding, and the code length indicates an output bit sequence length of encoding. In a case of designing an operation of SCL decoding without considering the generation of the dummy parity bit, performance of the receiver may be lower than expected. To solve this problem, the present disclosure proposes a technique for achieving targeted reception performance based on whether a dummy parity bit occurs in the 5G NR polar code system.

**[Technical Solution]**

According to embodiments of the present disclosure, a method performed by a device in a communication system and a broadcasting system may comprise receiving a signal considered to be encoded based on a polar code. The method may comprise identifying a configuration of a polar code for at least one information bit, at least one frozen bit, and at least one parity bit generated by at least one outer code of the signal. The method may comprise performing a decoding of the signal, based on the configuration of the polar code. The performing the decoding may comprise determining at least one of settings related to error detection or validity determination of the decoder, such as the number of parity bits to be used for the error detection and the number of attempts of an error detection test, and the like. The determination may be performed based on at least one value among a code parameter such as a code dimension, a code length, and a code rate, a target error detection capability or a configuration value corresponding thereto, and/or information on a code configuration such as a dummy parity bit.

In embodiments of the present disclosure, an apparatus performed by a device in a communication system or a broadcasting system may comprise memory, at least one transceiver, and at least one processor. The at least one processor may be configured to receive a signal encoded based on a polar code. The at least one processor may be configured to identify a configuration of a polar code for at least one information bit, at least one frozen bit, and at least one parity bit generated by at least one outer code of the signal. The at least one processor may be configured to perform a decoding of the signal, based on the configuration of the polar code. To perform the decoding, the at least one processor may be configured to determine at least one of settings related to error detection or validity determination of the decoder, such as the number of parity bits to be used for the error detection and the number of attempts of an error detection test, and the like. The determination may be performed based on at least one value among a code parameter such as a code dimension, a code length, and a code rate, a target error detection capability or a configuration value corresponding thereto, and/or information on a code configuration such as a dummy parity bit.

In embodiments of the present disclosure, a method performed by a device in a communication system or a broadcasting system is provided. The method may comprise obtaining a signal. The method may comprise identifying, based on at least one information bit of the signal and a rate-matching size for a polar code, information on at least one dummy parity-check (PC) bit among at least one PC bit of the signal. The method may comprise identifying, based on the information on the at least one dummy PC bit, a decoder configuration for error detection and error correction. The method may comprise performing a decoding of the signal based on the decoder configuration. The at least one dummy PC bit may include a bit, among the at least one PC bit, that has a fixed value irrespective of one or more preceding bits of the decoding.

In embodiments of the present disclosure, a device is provided in a communication system or a broadcasting system. The device may comprise memory, at least one transceiver, and at least one processor coupled to the memory and the at least one transceiver. The at least one processor may be configured to obtain a signal. The at least one processor may be configured to identify, based on at least one information bit of the signal and a rate-matching size for a polar code, information on at least one dummy parity-check (PC) bit among at least one PC bit of the signal. The at least one processor may be configured to identify, based on the information on the at least one dummy PC bit, a decoder configuration for error detection and error correction. The at least one processor may be configured to perform a decoding of the signal based on the decoder configuration. The at least one dummy PC bit may include a bit, among the at least one PC bit, that has a fixed value irrespective of one or more preceding bits of the decoding.

In embodiments of the present disclosure, a device is provided in a communication system or a broadcasting system. The device may comprise memory storing instructions, a transceiver, and a processor. The instructions, when executed by the at least one processor, may cause the device to identify, based on at least one information bit of a signal and a rate-matching size for a polar code, information on at least one dummy parity-check (PC) bit among at least one PC bit of the signal, identify, based on the information on the at least one dummy PC bit, a decoder configuration for error detection and error correction, and perform a decoding of the signal based on the decoder configuration, and the at least one dummy PC bit may include a bit, among the at least one PC bit, that has a fixed value irrespective of one or more preceding bits of the decoding.

In embodiments of the present disclosure, a non-transitory computer readable storage medium is provided. The non-transitory computer readable storage medium may store instructions, that cause, when executed by a processor of a device, the device to perform operations including obtaining a signal, identifying, based on at least one information bit of the signal and a rate-matching size for a polar code, information on at least one dummy parity-check (PC) bit among at least one PC bit of the signal, identifying, based on the information on the at least one dummy PC bit, a decoder configuration for error detection and error correction, and performing a decoding of the signal based on the decoder configuration. The at least one dummy PC bit may include a bit, among the at least one PC bit, that has a fixed value irrespective of one or more preceding bits of the decoding.

[Advantageous Effects]

A device and a method according to embodiments of the present disclosure can achieve high reception performance (e.g., error detection performance, a validity determination rate, error correction performance) by performing decoding, error detection, and validity determination based on configuration information of at least one polar code including the number of dummy parity bits.

The effects that can be obtained from the present disclosure are not limited to those described above, and any other effects not mentioned herein will be clearly understood by those having ordinary knowledge in the art to which the present disclosure belongs, from the following description.

[Description of the Drawings]

FIG. 1 illustrates a communication system or a broadcasting system.
FIG. 2 illustrates an example of a functional configuration of a device in a communication system or a broadcasting system.
FIG. 3 illustrates an example of an encoding process using a polar code.
FIG. 4 illustrates an example of a process of transmitting a codeword vector generated by a transmitter through a channel.
FIG. 5 illustrates an example of a decoding process using a polar code.
FIG. 6 illustrates examples of a transmission scenario between a transmitter and a receiver.
FIG. 7 illustrates a configuration of a polar code decoder including a function of decoding and determining validity of a decoding result.
FIG. 8 illustrates an example of a process of generating a PC bit using a circular shift register.
FIG. 9 illustrates the number of dummy parity check (PC) bits in a 3rd generation partnership project (3GPP) new radio (NR) uplink polar code system.
FIG. 10 illustrates a false alarm rate (FAR) according to a payload size.
FIG. 11 illustrates an example of a configuration of a polar code decoder for decoding and determining validity of a decoding result based on a dummy PC bit.
FIG. 12 illustrates an FAR according to a payload size when decoding based on a dummy PC bit.

FIG. 13 illustrates the number of dummy PC bits in a 3GPP NR uplink polar code system according to a constraint of a code rate.

**[Mode for Invention]**

Hereinafter, an embodiment of the present disclosure will be described in detail with the accompanying drawings.

In describing an embodiment, description of technical content well known in the technical field to which the present invention belongs and not directly related to the present invention will be omitted. This is to convey the gist of the present invention more clearly without blurring by omitting unnecessary explanations.

For the same reason, some components are emphasized, omitted, or schematically illustrated in the accompanying drawings. In addition, a size of each component does not entirely reflect the actual size. In each drawing, the same reference numbers are assigned to the same or corresponding component.

An advantage and a feature of the present invention and a method for achieving them will become apparent with reference to embodiments described below in detail together with the accompanying drawings. However, the present invention is not limited to the embodiments disclosed below, but may be implemented in various different forms, and this embodiments are provided only to ensure that the disclosure of the present invention is complete and to fully inform those of ordinary knowledge in the technical field to which the present invention belongs, and the present invention is only defined by the scope of the claim. Throughout the specification, the same reference numerals may refer to the same components.

In this case, it will be understood that each block of processing flowchart drawings and combinations of the flowchart drawings may be performed by computer program instructions. Since these computer program instructions may be mounted on a processor of a general-purpose computer, a special-purpose computer, or other programmable data processing equipment, the instructions performed through the processor of the other programmable data processing equipment also generate a means to perform functions described in the flowchart block(s). Since these computer program instructions may be stored in computer-available or computer-readable memory that may be directed to the computer or the other programmable data processing equipment to implement functions in a specific way, the instructions stored in the computer-available or computer-readable memory may produce a manufacturing item including the instruction means performing the functions described in the flowchart block(s). Since the computer program instructions may be mounted on the computer or the other programmable data processing equipment, the instructions that perform the computer or the other programmable data processing equipment by generating a process executed by the computer as a series of operational steps is performed on the computer or the other programmable data processing equipment, may provide steps for executing the functions described in the flowchart block(s).

In addition, each block may indicate a module, a segment, or a portion of a code including one or more executable instructions for executing a specified logical function(s). In addition, it should be noted that in some alternative implementations, the functions mentioned in the blocks may occur out of order. For example, it is possible for two blocks illustrated in succession to be performed substantially simultaneously, or for the blocks to be performed in reverse order according to a corresponding function.

In this case, the term '~unit' used in this embodiment refers to a software component or a hardware component such as FPGA or ASIC, and '~unit' performs certain roles. However, '~unit' is not limited to software or hardware. '~unit' may be configured to be in an addressable storage medium or may be configured to reproduce one or more processors. Therefore, as an example, '~unit' includes components such as software components, object-oriented software components, class components, and task components, processes, functions, features, procedures, subroutines, segments of program code, drivers, firmware, microcode, circuitry, data, database, data structures, tables, arrays, and variables. A function provided within the components and '~unit' may be combined into a smaller number of components and '~units' or further separated into additional components and '~units'. In addition, the components and '~units' may be implemented to reproduce one or more central processing units (CPUs) or graphic processing units (GPUs) in a device or a secure multimedia card.

Hereinafter, various embodiments will be described in detail with reference to the accompanying drawings. In this case, it should be noted that the same components in the accompanying drawings are indicated by the same reference numerals as possible. In addition, the drawings of the present invention attached below are provided to help understanding of the present invention, and it should be noted that the present invention is not limited to a form or a disposition illustrated in the drawings of the present invention. Furthermore, detailed descriptions of a known function and a configuration that may obscure the gist of the present invention will be omitted. It should be noted that only a portion necessary to understand an operation according to various embodiments of the present invention is described in the following description, and a description of a portion other than above will be omitted so as not to disperse the gist of the present invention.

A term referring to a signal (e.g., a signal, information, a message, or signaling), a term referring to a resource, a term for a calculation state (e.g., a step, an operation, or a procedure), a term referring to data (e.g., a packet, a user stream, information, a bit, a symbol, or a codeword), a term referring to a channel, a term referring to a network entity, a term referring to a component of a device, and the like, that are used in the following description, are exemplified for convenience of explanation. Therefore, the present disclosure is not limited to terms described below, and another term having an equivalent technical meaning may be used.

In the present disclosure, an expression 'greater than' or 'less than' may be used to determine whether a certain condition is satisfied or fulfilled, but this is only a description for expressing an example and does not exclude a description of 'greater than or equal to' or 'less than or equal to'. A condition written as 'greater than or equal to' may be replaced with ' greater than', a condition written as 'less than or equal to' may be replaced with 'less than', and a condition written as 'greater than or equal to and less than' may be replaced with 'greater than and less than or equal to'. In addition, hereinafter, 'A' to 'B' refer to at least one of elements from A (including A) to B (including B). Hereinafter, 'C' and/or 'D' refer to including at least one of 'C' or 'D', that is, {'C', 'D', and 'C' and 'D'}.

The present disclosure describes embodiments using terms used in some communication standards (e.g., a 3rd Generation Partnership Project (3GPP), an extensible radio access network (xRAN), and an open-radio access network (O-RAN)), but this is only an example for explanation. The embodiments of the present disclosure may be easily modified and applied to another communication system and another broadcasting system.

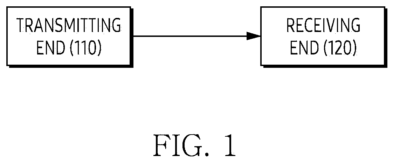

FIG. 1 illustrates a communication system and a broadcasting system.

Referring to FIG. 1, as a portion of a device or nodes using a wired or wireless channel or a channel in which a wired channel and a wireless channel are combined in a wired and wireless communication system or broadcasting system, a transmitting end 110 and a receiving end 120 are exemplified. FIG. 1 illustrates one transmitting end 110 and one receiving end 120, but the communication system and the broadcasting system may include a plurality of transmitting ends or a plurality of receiving ends. In addition, for convenience of explanation, in the present disclosure, the transmitting end 110 and the receiving end 120 are described as separate objects, but functions of the transmitting end 110 and the receiving end 120 may be exchanged. For example, in a case of uplink of a cellular or mobile system, the transmitting end 110 may be a terminal and the receiving end 120 may be a base station. In a case of downlink, the transmitting end 110 may be a base station and the receiving end 120 may be a terminal.

The base station is a network infrastructure that provides wireless access to the terminal. The base station has coverage defined based on a distance capable of transmitting a signal. In addition to a base station device, the base station may be referred to as a massive multiple input multiple output(MIMO) unit (MMU), an access point (AP), eNode B (eNB), a 5th generation node, 5G NodeB (5G NB), a wireless point, a transmission/reception point (TRP), an access unit, a distributed unit (DU), a virtualized distributed units (vDU), a radio unit (RU), a remote radio head (RRH), or another term having the same technical meaning. The base station may transmit a downlink signal or receive an uplink signal.

The terminal is a device used by a user, and performs communication with the base station through the wired or wireless channel. In some cases, the terminal may be operated without user involvement. That is, the terminal, which is a device that performs machine type communication (MTC), may not be carried by the user. In addition to the terminal, the terminal may be referred to as user equipment (UE), a mobile station, a subscriber station, customer premises equipment (CPE), a remote terminal, a wireless terminal, an electronic device, or a terminal for a vehicle, a user device, or another term having the same technical meaning.

Although not illustrated in FIG. 1, in addition to the communication between the base station and the terminal, the terminal may perform direct communications with other terminals. Such communications may be configured or set as sidelink. For example, it may support vehicle communication between the terminal illustrated in FIG. 1 and another terminal. In a case of the vehicle communication, standardization work for vehicle-to-everything (V2X) technology based on a device-to-device (D2D) communication structure in LTE system was completed in 3GPP release 14 and release 15, and currently standardization work for NR V2X technology has been carried out in 5G NR release 16.

A transmitting end and a receiving end may be variously defined according to a link formed between communication nodes. According to an embodiment, the transmitting end 110 may be a base station, and the receiving end 120 may be a terminal. In addition, according to another embodiment, the receiving end 120 may be a base station and the transmitting end 110 may be a terminal. In addition, according to another embodiment, both a transmitting end and a receiving end may be terminals that communicate through the sidelink. Hereinafter, the present disclosure describes a subject transmitting a signal as a transmitting end and a subject receiving a signal as a receiving end, but it is only a functional expression to explain a signal processing process and is not interpreted as limiting a specific embodiment.

In embodiments, the transmitting end 110 generates a codeword by encoding information bits based on polar codes, and the receiving end 120 may decode a signal of the received codeword based on the polar codes. Subchannel allocation with respect to input bits may be performed. Each input bit for encoding of the polar codes may be analyzed and interpreted as passing through a subchannel, which is a virtual channel of different quality, by channel polarization. In this case, each subchannel may be referred to as a split channel or a synthesized channel (or a synthetic channel). After the subchannel allocation, the transmitting end 110 may perform encoding on the polar codes using a generator matrix. The receiving end 120 may perform decoding based on the polar codes. For example, the receiving end 120 may perform decoding based on the polar codes, based on a successive cancellation (SC) operation.

In embodiments, the transmitting end 110 may perform encoding based on an encoding parameters and a scheduling parameter that are different from the receiving end 120 due to various causes. The receiving end 120 may perform decoding based on the encoding parameter and the scheduling parameter that are different from the transmitting end 110. That is, an encoding operation of the transmitting end 110 and a decoding operation of the receiving end 120 may be performed by being defined or set by different settings. For example, an error correction code technique used by the transmitting end 110 and an error correction code technique used by the receiving end 120 may be different from each other. For example, even if the transmitting end 110 and the receiving end 120 use the same type of error correction code, a code parameter (e.g., a code dimension, a code length, or a modulation order) may be different. The code dimension indicates the number of encoding input bits or the number of information bits. The code length indicates the number of encoding output bits or the number of codeword bits. For example, even if the transmitting end 110 and the receiving end 120 use the same type of error correction code and the same code parameter, a scheduling parameter of the transmitting end 110 may be different from a scheduling parameter of the receiving end 120. Since scheduling parameters for a communication resource used are different, an allocation position on time and a frequency in which a signal is transmitted in the transmitting end 120 and the receiving end 120, and an allocation position of an antenna and a layer in a MIMO system, may be different. According to the examples, as a result, the signal inputted from the receiving end 120 may not correspond to a setting (e.g., the code parameter, the scheduling parameter, and the like) to be decoded. Accordingly, the inputted signal may be random or random-like.

In embodiments, the receiving end 120 may determine that a signal has been received even though the signal has not been transmitted to the transmitting end 110 due to various causes. The receiving end 120 may attempt to decode the signal determined to be received. For example, the receiving end 120 may misidentify a receiving component including background noise and/or interference as an intended signal and perform decoding on the receiving component.

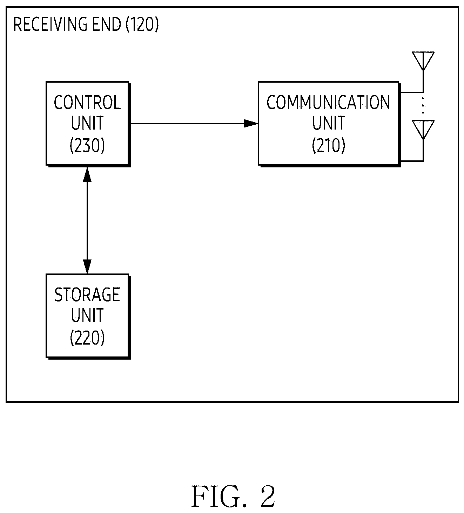

FIG. 2 illustrates an example of a functional configuration of a device in a communication system or a broadcasting system. That is, the configuration illustrated in FIG. 2 may be understood as the configuration of the transmitting end 110 or the receiving end 120 of FIG. 1. Hereinafter, a term such as '~ unit' and '~ equipment' used refer to a unit that processes at least one function or operation, which may be implemented by hardware, software, or a combination of the hardware and the software.

Referring to FIG. 2, the device may include a communication unit 210, a storage unit 220, and a control unit 230.

The communication unit 210 may perform functions for transmitting and receiving a signal through a wired and wireless channel. For example, the communication unit 210 may perform a function of changing between a baseband signal and a bitstream according to a physical layer standard of a system. For example, in a case that the transmitting end 110 transmits data, the communication unit 210 may generate complex symbols by encoding and modulating a transmission bit stream. In addition, in a case that the receiving end 120 receives the data, the communication unit 210 may estimate or restore the transmitted bit stream by demodulating and decoding the baseband signal. In addition, the communication unit 210 may up-convert the baseband signal into a radio frequency (RF) band signal, and then transmit it through the antenna, and down-convert the RF band signal received through the antenna into a baseband signal.

To this end, the communication unit 210 may include a transmission filter, a reception filter, an amplifier, a mixer, an oscillator, a digital-to-analog converter (DAC), an analog-to-digital converter (ADC), and the like. Also, the communication unit 210 may include a plurality of transmission/reception paths. Furthermore, the communication unit 210 may include at least one antenna array composed of a plurality of antenna elements. In terms of hardware, the communication unit 210 may be composed of a digital unit and an analog unit, and the analog unit may be composed of a plurality of sub-units according to operating power, an operating frequency, and the like. In addition, the communication unit 210 may include an encoding unit for performing encoding according to various embodiments of the present disclosure. In addition, the communication unit 210 may include a decoding unit for performing decoding according to various embodiments of the present disclosure.

The communication unit 210 transmits and receives a signal as described above. Accordingly, the communication unit 210 may be referred to as a 'transmission unit', a 'reception unit', or a 'transmission/reception unit'. In addition, in the following description, the transmission and reception operations performed through the wired and wireless channel are used as a meaning including that processing is performed by the communication unit 210 as described above. According to an embodiment, the communication unit 210 may include one or more transceivers. In addition, in a case that the device of FIG. 2 is the base station, the communication unit 210 may further include a backhaul communication unit for communication with another network entity connected through a backhaul network.

The storage unit 220 may store data such as a basic program, an application program, setting information, and the like, for the operation of the transmitting end 110 or the receiving end 120. The storage unit 220 may be composed of volatile memory, nonvolatile memory, or a combination of volatile memory and nonvolatile memory. In addition, the storage unit 220 may provide stored data in response to a request from the control unit 230. According to an embodiment, the storage 220 may include one or more memories.

The control unit 230 may control overall operations of the device. For example, the control unit 230 may transmit and receive a signal through the communication unit 210. Additionally, the control unit 230 may record or read data in the storage unit 220. To this end, the control unit 230 may include at least one processor or microprocessor, or may be a portion of the processor. According to various embodiments, the control unit 230 may control the device to perform operations according to various embodiments described below.

In the present disclosure, various words having the same meaning may be used to refer to channel coding. The channel coding may be referred to as error correction codes (ECC), error detection codes (or error detection codes), forward error correction (FEC), and the like. An operation performed by a transmitter may be referred to by a term such as channel encoding, encoding, and the like, and a unit for performing the operation may be referred to as a channel encoder, encoder, an encoding unit, and the like. For example, the transmitter may include an encoder. An operation performed by a receiver may be referred to as channel decoding process, channel decoding, decoding process, decoding, and the like, and a unit of performing the operation may be referred to as a channel decoding processor, a channel decoder, a decoding processor, a decoder, and the like. The word may be clearly understood by those skilled in the art to which the present disclosure belongs. For example, the receiver may include a decoder.

In addition, a commonly used mathematical symbol is used in a process of explaining the present disclosure in detail. Such mathematical symbol may be clearly understood by those of ordinary skill in the technical field to which the present disclosure belongs. Representatively, the following mathematical symbol is used in the present disclosure.

- A calligraphic character (e.g., $\mathcal{A}$) is used to indicate a set.
- Unless otherwise stated throughout the present disclosure, it is assumed that an index of a first element of the set, a sequence, and a vector starts from 0 (zero-based numbering).

- Symbols $\mathbb{N}$, $\mathbb{Z}$, and $\mathbb{R}$ are used to indicate a set of natural numbers, a set of integers, and a set of real numbers, respectively.
- A symbol $\mathbb{F}_2$ indicates a binary field.
- For a non-negative integer $n$, $\mathbb{Z}_n$ indicates a set of $n$ consecutive integers from 0 to $n$ - $1$. That is,

$$\mathbb{Z}_n = \{0, 1, \ldots, n-1\}.$$

- A boldface lowercase letter (e.g., **a**) is used to indicate to a vector, and A boldface uppercase letter (e.g., $A$) is used to indicate to a matrix. In a case of a vector, unless otherwise stated, it indicates a column vector.
- For the vector **a** and the matrix A, $\mathbf{a}^T$ and $\mathbf{A}^T$ indicate respective transposes.
- For the vector **a** and two non-negative integers $i$ and $j$, $\mathbf{a}_i^j$ indicates a sub-vector composed of continuous elements from the $i$-th element to the $j$-th element of the vector **a**. That is, $\mathbf{a}_i^j$ is ($a_i, a_{i+1}, \ldots, a_j$).

A polar code, which is an error correction code proposed by E. Arikan, is the first error correction code to be proven to achieve channel capacity, which is the limit of data transmission performance, in a binary discrete memoryless channel (B-DMC) while having a low level of encoding/complexity performance that may be implemented [1]. Decoding methods based on the polar code and the successive cancellation (SC) enable superior error-correction performance when transmitting a short length of code compared to other channel codes. Because of these advantages, in a 3GPP New Radio (NR), which is a 5th generation (5G) mobile communication standard, the polar code is used to transmit control information having a short length.

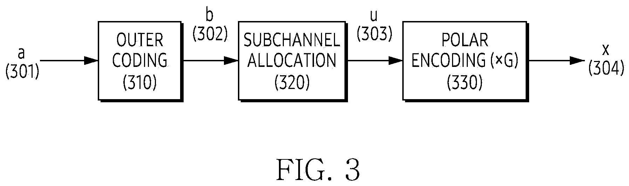

FIG. 3 illustrates an example of an encoding process using a polar code.

Referring to FIG. 3, an information vector that a transmitter (e.g., the transmitting end 110) intends to transmit to a receiver (e.g., the receiving end 120) is written as $\mathbf{a} \in \mathbb{F}_2^A$ 301, herein, $A$ is the number of information bits.

The information vector **a** 301 may be encoded by a concatenated outer coding 310. An outer codeword vector generated through the encoding is written as $\mathbf{b} \in \mathbb{F}_2^K$ 302. Herein, $K$ is a length of the outer codeword vector, and $K$ is greater than or equal to $A$. In an embodiment, concatenated outer coding may not be used, and naturally **b** is the same as the inputted information vector **a** and is $K = A$. In an embodiment, one or more concatenated outer coding may be used, in this case, it becomes $K > A$. That is, the concatenated outer coding used in an embodiment may be composed of a combination of one or more different encoding techniques. For a concatenated outer coding technique used in embodiments of the present invention, there are a cyclic redundancy check (CRC) code, a parity check (PC) code, and the like, and are not limited to any form and configuration.

The concatenated outer coding used may be a systematic code. In this case, the outer codeword vector 302 may be configured in a form in which bits of the information vector 301 are mixed with parity bits generated by the outer coding.

Each bit of the outer codeword vector **b** 302 is mapped or allocated to a portion of an encoder input vector $\mathbf{u} \in \mathbb{F}_2^N$ 303 for encoding of the polar code, and this process is called subchannel allocation 320. The subchannel allocation may be understood as a process for using a better subchannel according to channel polarization achieved by encoding and decoding of the polar code. Herein, $N$ is a code length of the polar code used, and is determined by the number of squares of 2 in a binary polar code. That is, for a random natural number $n$, $N = 2^n$ or $n = \log_2 N$. Typically, it is $N > K$, and a mother code rate of the polar code is determined by $K/N$.

An encoder input vector **u** generated by the subchannel allocation may be composed of information bits and parity bits of the outer codeword vector **b**, and additionally inserted frozen bits. Accordingly, the encoder input vector **u** includes at least one outer coding bit and at least one frozen bit. In a case that systematic outer coding is performed, the encoder input vector **u** includes at least one information bit, at least one parity bit, and at least one frozen bit.

The encoder input vector **u** generated by the subchannel allocation may include at least one frozen bit to achieve a target coding rate. A value of the frozen bit is pre-determined (i.e., it is not obtained as a result of the encoding and decoding process) and is usually fixed to 0.

The encoder input vector **u** generated by the subchannel allocation may include at least one parity bit. For effective use in the sequential bit decoding operation of the receiver, the parity bit may be disposed as if they were causally generated on the encoder input vector **u**. Herein, the parity bit being causally generated means that the parity bit is generated or obtained on the encoder input vector based on all or a portion of other preceding bits, which are prior (i.e., having smaller index) to the parity bit. For example, if $u_i$ is a parity bit in the encoder input vector **u**, $u_i$ may be determined based on a linear combination of all or a portion of a set $\{u_0, u_1, \ldots, u_{i-1}\}$ of the preceding bits. For example, the parity bit $u_i$ may be generated by the following Equation 1.

【Equation 1】

$$u_i = \sum_{k=0}^{i-1} h_k^{(i)} u_k$$

In the Equation 1, $h_k^{(i)} \in \mathbb{F}_2$ is a coefficient for a preceding bit $k \in \{0, 1, \ldots, i-1\}$ for generation of the parity bit $u_i$, and all operations are defined on a binary field. By the Equation 1, the parity bit $u_i$ is determined as a binary sum of a subset of the preceding bits $\{u_0, u_1, \ldots, u_{i-1}\}$. The generation of the causal parity bit as described above is to utilize a parity bit generation equation based on estimation of the preceding bits in a decoder of the polar code performing sequential bit decoding. The parity bit generation equation is described in more detail in an operation of the receiver (or decoder) to be described later.

As a result of the subchannel allocation, the encoder input vector **u** 303 includes the outer codeword vector **b** 302 in a form that encloses it. In an example, an order of bits of the outer codeword vector **b** 302 in which the encoder input vector **u** 303 encloses may be the same as before. That is, the outer codeword vector **b** 302 appearing in the encoder input vector **u** 303 is dispersed due to the frozen bit, and the order thereof may be maintained. For example, if the outer codeword vector **b** $= (b_0, b_1, b_2, b_3)$ of length $K = 4$ is assigned to the encoder input vector **u** of length $N = 8$, the result may be the same as **u** $= (0, 0, 0, b_0, 0, b_1, b_2, b_3)$. As in the example, mapping that maintains the order is used in a 3GPP NR polar code system and the like. This mapping method is not essential for the implementation of the present disclosure. However, the mapping method may be considered as an embodiment for effectively using a parity bit in a receiver decoding operation.

After the subchannel allocation, in polar encoding 330, the transmitter may generate a codeword vector $\mathbf{x} \in \mathbb{F}_2^N$ 304 by multiplying the encoder input vector **u** 303 with a generator matrix $\mathbf{G} \in \mathbb{F}_2^{N \times N}$. The codeword vector may be referred to as an encoder output vector or the like. In addition, since the codeword vector **x** may be modified by the subsequent operation of the transmitter, it may be referred to as a mother codeword vector for distinction.

For example, the codeword vector **x** may be generated by the following Equation 2.

【Equation 2】

$$\mathbf{x} = \mathbf{u}\mathbf{G}$$

In the Equation 2, both the encoder input vector **u** and the codeword vector **x** are row vectors of length $N$.

In an embodiment, the generation matrix **G** of the Equation 2 may be defined as in Equation 3 below.

**【Equation 3】**

$$\mathbf{G} = \mathbf{B}_N \mathbf{F}^{\otimes n}$$

The generation matrix of the Equation 3 is in a form presented in the document [1] where the polar code was first proposed. In the Equation 3, $\mathbb{F}$ is called a polarization kernel and is $\mathbf{F} = \begin{bmatrix} 1 & 0 \\ 1 & 1 \end{bmatrix}$. The superscript $\otimes n$ operation for the polarization kernel $\mathbb{F}$ refers to Kronecker power of $n$ times. The Kronecker power means a recursive matrix operation such as $\mathbf{F}^{\otimes 2} = \begin{bmatrix} \mathbf{F} & 0 \\ \mathbf{F} & \mathbf{F} \end{bmatrix}$ and $\mathbf{F}^{\otimes 3} = \begin{bmatrix} \mathbf{F}^{\otimes 2} & 0 \\ \mathbf{F}^{\otimes 2} & \mathbf{F}^{\otimes 2} \end{bmatrix}$. Thus, $\mathbf{F}^{\otimes n} \in \mathbb{F}_2^{N \times N}$ is a binary matrix of size $N \times N$. In addition, $\mathbf{F}^{\otimes n} \in \mathbb{F}_2^{N \times N}$ is a bit-reversal permutation matrix of size $N \times N$. $\mathbf{B}_N$ may provide an operation that generates and dispose a new index by converting each element index of a given vector into a binary representation and reversing it. For example, when a vector $(a_0, a_1, a_2, a_3, a_4, a_5, a_6, a_7)$ with length 8 is multiplied by $\mathbf{B}_8$, a vector $(a_0, a_4, a_2, a_6, a_1, a_5, a_3, a_7)$ is generated in which indices are bit-reversal permutated.

In another embodiment, the generation matrix $\mathbf{G}$ of the Equation 2 may be defined as in Equation 4 below.

**【Equation 4】**

$$\mathbf{G} = \mathbf{F}^{\otimes n}$$

The generation matrix $\mathbf{G}$ of the Equation 4 is defined without the bit-reversal permutation matrix $\mathbf{B}_N$, and a generation matrix in a form of the Equation 4 may be used in the 3GPP NR system [3] and the like.

Hereinafter, it is assumed that the generation matrix $\mathbf{G} = \mathbf{F}^{\otimes n}$ of the Equation 4 is used unless otherwise stated. However, content to be described below and content of the present disclosure may be applied equally by performing simple additional operations (e.g., applying bit-reversal permutation or its reverse permutation to one of the encoder input vector $\mathbf{u}$ or the codeword vector $\mathbf{x}$) in a system considering the generation matrix $\mathbf{G} = \mathbf{B}_N \mathbf{F}^{\otimes n}$ defined in the Equation 3. Whether the bit-reversal permutation is included in the generation matrix does not affect an operation, a characteristic, and an effect of the present invention.

For the effective description of the present disclosure, a simple example for the polar code of length 8 is presented as Example 1. In FIG. 3, first, the information vector $\mathbf{a}$ 301 of length 3 is given as $\mathbf{a} = (a_0, a_1, a_2)$. The transmitter may generate a parity bit of 1 bit by the outer coding 310. The transmitter may obtain the outer codeword vector $\mathbf{b} = (b_0, b_1, b_2, b_3)$ 302 of length 4. For example, the outer codeword vector $\mathbf{b}$ 302 is calculated by $(a_0, a_1, a_0 + a_1, a_2)$. The outer codeword vector $\mathbf{b}$ 302 is mapped to the encoder input vector $\mathbf{u}$ 303 by the subchannel allocation 320. Herein, when the 0, 1, 2, and 4th indexes are allocated to the frozen bit, and the 3, 5, 6, and 7th indexes are allocated to the outer codeword vector bit, the encoder input vector 302 is given as $(u_0, u_1, u_2, u_3, u_4, u_5, u_6, u_7) = (0,0,0,b_0, 0, b_1,b_2, b_3)$. According to a generation relationship of the outer codeword vector $\mathbf{b}$ 302, the encoder input vector $\mathbf{u}$ 302 may be rewritten as $(u_0, u_1, u_2, u_3, u_4, u_5, u_6, u_7) = (0,0,0, b_0, 0, b_1, b_2, b_3)$. The transmitter may generate the codeword vector $\mathbf{x}$ 304 by multiplying the generation matrix using polar encoding to the encoder input vector $\mathbf{u}$ 303.

A causal generation relationship of the parity bit may be confirmed from a code configuration of the Example 1. For example, the parity bit $u_6$ mapped to the encoder input vector $\mathbf{u}$ is given as $u_6 = u_3 + u_5$ by the outer coding and the subchannel allocation operation. According to a definition of the causal generation, the parity bit $u_6$ is given as a linear combination of the preceding bits.

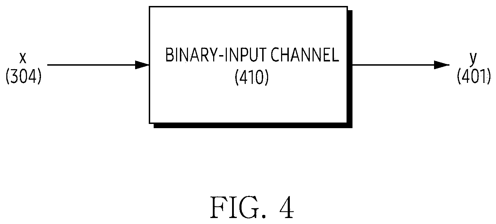

FIG. 4 illustrates an example of a process of transmitting a codeword vector generated by a transmitter through a channel. In FIG. 4, a codeword vector $\mathbf{x}$ 304 generated through the series of processes may be transmitted through the channel.

Referring to FIG. 4, the generated codeword vector $\mathbf{x}$ 304 may be transmitted through a binary-input channel 410. A receiver obtains a reception symbol vector $\mathbf{y}$ 401 (herein, $\mathbf{y} \in \mathcal{Y}^N$) corresponding to the codeword vector. Herein, the alphabet $\mathcal{Y}$ for the reception symbol is determined according to a type of the channel and need not be a binary field $\mathbb{F}_2$. A transition from a codeword sequence $\mathbf{x}$ to the reception symbol vector $\mathbf{y}$ by the binary-input channel may correspond to a result obtained through various operations such as rate matching and rate dematching, interleaving and deinterleaving, scrambling and descrambling, modulation and demodulation as well as a physical channel. The rate matching and the rate dematching are related to a process of matching a code length and a code rate by transforming the codeword vector $\mathbf{x}$ into

repetition, puncturing, shortening, and the like. The interleaving and the deinterleaving relate to a process of changing a disposition of bits. The scrambling and the descrambling relate to a process of transforming values of bits according to a given pattern. The modulation and the demodulation relate to a process of converting generated bits into physical signals and converting them back into reception symbols for each bit. Each of the operations may be clearly understood by those skilled in the art to which the present disclosure belongs. The binary-input channel may be defined as an end-to-end transition from **x** to **y** in consideration of all intermediate operations.

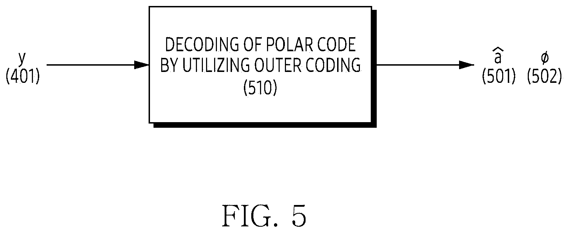

FIG. 5 illustrates an example of a decoding process using a polar code.

Referring to FIG. 5, operation 510 of performing decoding of the polar code based on a reception symbol vector **y** 401 may be performed. Information, a metric, and the like on the reception symbol vector **y** may be represented in an appropriate form according to system requirements and operations. For example, in an embodiment of the present disclosure, a log likelihood ratio (LLR) for each codeword bit may be used. The LLR is a value calculated in logarithmic units for a ratio of a probability with respect to a codeword bit based on the received observation. For example, an LLR for the i-th codeword bit may be calculated as Equation 5 in the following definition based on a corresponding observation $y_i$.

【Equation 5】

$$\lambda_i = \log \frac{p(y_i | x_i = 0)}{p(y_i | x_i = 1)}$$

$\lambda_i$ refers to the LLR for the *i*-th codeword bit .

In order to indicate the LLR, another type of parameter having the same technical meaning as in the Equation 5 may be defined. For example, in the Equation 5, a probability of bit value 0 is used in the numerator, and a probability of bit value 1 is used in the denominator, and the probability applied to the numerator and the probability applied to the denominator may be reversed. In other words, in order to represent the LLR, the probability of bit value 1 in the numerator and the probability of bit value 0 in the denominator may be used.

An LLR for each codeword bit may be calculated or obtained by various methods. In particular, in a case that high-order modulation is used, since multiple bits are tied together and transmitted and received as one symbol, the LLR for each bit in the symbol may be calculated by an appropriate procedure and process. A calculation process of the LLR may be clearly understood by those skilled in the art to which the present disclosure belongs. Embodiments of the present disclosure may be applied to various forms of reception symbol vectors and variations thereof, and are not limited to any specific form.

An LLR vector for the codeword vector **x** calculated based on the reception symbol vector **y** 401 may be written as $\Lambda = (\lambda_0, \lambda_1, \ldots, \lambda_{N-1})$. The LLR is described below based on what is defined as the Equation 5, but the embodiments of the present disclosure are not limited to a specific calculation method and definition of the LLR. By the definition of the Equation 5, if a probability of bit value 0 of a target codeword bit is greater than a probability of bit value 1, the LLR becomes positive. Conversely, if a probability of bit value 1 of the target codeword bit is greater than a probability of bit value 0, the LLR becomes negative. Since there is no information on a bit value of a codeword bit punctured in the operation of the binary-input channel, a corresponding LLR value may be set to 0. Since a value of the shortened codeword bit in the operation of the binary-input channel is clearly known, the corresponding LLR value may be set to the positive (the bit value 0) or the negative (the bit value 1) having the maximum absolute value set in the system. In a case that the codeword bit is repeatedly transmitted two or more times in the operation of the binary-input channel, a receiver may calculate an LLR for each repeatedly transmitted bit and then perform soft combining on the calculation results. The receiver may set the results obtained through the soft combining as the LLR value of the target codeword bit. For example, the soft combining may be performed by adding each LLR.

The reception symbol vector **y** 401 or the LLR vector $\Lambda$ generated therefrom may be processed by the decoding operation of the polar code 510. The generation process of the LLR vector $\Lambda$ may be described by being included in the decoding operation 510 of the polar code. The decoding operation of the polar code will be described in more detail later. As a decoding result, **â** 501, which is an estimate of the information vector **a** 301 may be obtained. In addition, the receiver (or a decoder) may additionally output  502, which is a report variable indicating validity of the decoding result. The report variable  502 may be a binary variable indicating whether the decoding result is valid or not. In addition, the report variable  502 may be a variable indicating three or more states for the reception signal or the decoded result.

Hereinafter, an embodiment of the decoding operation 510 of the polar code will be described in detail. The decoding of the polar code may operate based on a successive-cancellation (SC) method presented in the document [1]. SC-based decoding may include general SC decoding, SC-list (SCL) decoding, SC-stack (SCS) decoding, or SC-flip (SCF) decoding. The SC-based decoding is characterized in that an encoder input vector $\mathbf{u} = (u_0, u_1, \ldots, u_{N-1})$ is decoded in ascending order of indices, that is, each bit is sequentially decoded one by one in the $u_0, u_1, \ldots, u_{N-1}$ order.

Specifically, in the SC-based decoding, decoding for the $i$-th bit $u_i$ is performed by the following procedure.

① A decoding bit index $i$ is set to 0.

② Based on the reception signal, the estimation $\hat{u}_0, \hat{u}_1, \ldots, \hat{u}_{i-1}$ of the previously decoded bits, and a probability thereof, a probability such as an LLR for the $i$-th bit $u_i$, or a metric equivalent thereto, is calculated.

③ An estimation $\hat{u}_i$ of $u_i$ may be obtained based on the probability-based metric. In this case, a method of estimating a bit is changed according to whether the bit $u_i$ is an information bit, a frozen bit, or a parity bit. For example, if $u_i$ is an information bit, the estimation $\hat{u}_i$ may be determined based on the probability-based metric such as the LLR and the like. On the other hand, if $u_i$ is a frozen bit, the estimation $\hat{u}_i$ may be determined as a fixed value that is preset. Finally, if $u_i$ is a parity bit, the receiver may determine the estimation $\hat{u}_i$ through the given parity-check equation as illustrated in the Equation 1 based on the estimation $\hat{u}_0, \hat{u}_1, \ldots, \hat{u}_{i-1}$ of the preceding bits. Alternatively, the receiver may determine the decoding validity of the corresponding bit by comparing the value obtained by the parity-check equation with the estimate obtained based on probability-based metric such as the LLR and the like.

④ The receiver may increment the decoding bit index $i$ by one and repeat the processes ② and ③. By this sequential decoding and estimation, the estimation $\hat{u}_i$ of $u_i$ is reflected in decoding of the next bit $u_{i+1}$ in the successive cancellation method. This operation continues until the decoding bit index $i$ becomes $N - 1$ and decoding and an estimation of the last bit $u_{N-1}$ are completed.

As described above, the decoding of each bit may be performed based on bit values which have been previously decoded and estimated. For example, in the decoding of the bit $u_i$, the estimation $(\hat{u}_0, \ldots, \hat{u}_{i-1})$ for the preceding bits and probability information for it or a metric equivalent thereto, are used. Herein, each partial bit vector or sequence $(\hat{u}_0, \ldots, \hat{u}_{i-1})$ may be referred to as a list or a path. In addition, probability information obtained while performing decoding for each path or a metric equivalent to the probability information may be referred to as a path-metric (PM). The PM may be calculated based on various methods. In an embodiment, the method presented in the document [4] may be used.

The SC decoding is a method of selecting only one path when decoding each bit. The sequential bit decoding process may be interpreted as performing a search from a root in a binary decision tree. The SC decoding may mean performing depth-first search (DFS) in the binary decision tree.

The SCL decoding is a method of considering multiple candidate groups while maintaining paths of a predetermined list size $L$ when decoding each bit. The SCL decoding process may be seen as performing beam searching in the binary decision tree. When the list size $L$ is set to 1, there may be a difference in detailed operations, but SCL decoding consequently performs the same operation as the SC decoding.

An SCL decoder has $L$ paths $\left(\hat{u}_0^{(\ell)}, \ldots, \hat{u}_{i-1}^{(\ell)}\right)$, by performing sequential decoding up to a bit $u_{i-1}$. Herein, $\ell$ is a path index, and has a value from 0 to $L - 1$. In a case of early sequential decoding where the bit index $i - 1$ to be decoded is small, the number of valid paths may be less than $L$. In this case, the decoder may proceed with the next process only for a valid path, or ignore a decoding result for an invalid path after performing an entire process.

Consider a situation in which the SCL decoder sequentially decodes and estimates $u_i$, which is the next bit, after finishing decoding of $u_{i-1}$. Calculate PM for $\left(\hat{u}_0^{(\ell)}, \ldots, \hat{u}_{i-1}^{(\ell)}, 0\right)$ and $\left(\hat{u}_0^{(\ell)}, \ldots, \hat{u}_{i-1}^{(\ell)}, 1\right)$ for each path index $\ell$. Since two paths to $u_i \in \{0,1\}$ are derived from $L$ paths, a total number of candidate groups of paths to be considered at this stage is $2L$. The SCL decoder selects $L$ paths among the $2L$ path candidate groups and discards the rest. After decoding and estimating each bit, the number of paths considered is limited to $L$, and this limitation enables the receiver to process decoding for each bit within the limited physical resources (memory, computing device, and the like) and computing power.

A selection process of the path may vary according to whether $u_i$ is an information bit, a frozen bit, or a parity bit. For example, if $u_i$ is an information bit, the receiver may select the estimated $L$ paths based on the obtained PM. On the other hand, if $u_i$ is a frozen bit, the receiver may select $L$ paths by determining the estimation $\hat{u}_i$ as a previously known fixed value. Finally, if $u_i$ is a parity bit, the receiver may select $L$ paths by determining the estimation $L$ based on the given parity-check equation based on the estimation $\hat{u}_0, \hat{u}_1, \ldots, \hat{u}_{i-1}$ of the preceding bits, or may determine validity for each of the $L$ paths.

The validity determination for each path may be improved by using a parity bit generated by an outer code concatenated during or after the SCL decoding.

Among various outer concatenation codes, a cyclic redundancy check (CRC) code is generally used to determine validity of the final paths obtained after termination of the SCL decoding. For example, in a 3GPP NR polar code system, CRC codes of various lengths and forms are used as outer concatenation codes according to a situation. In general, parity bits generated by the CRC codes may be consecutively disposed behind the outer codeword vector **b** 302 illustrated in FIG. 3. In some situations, the parity bits may be distributed and disposed. Meanwhile, a distributed disposition is not essential, and the embodiments of the present disclosure are not limited to a specific disposition of the parity bits of the CRC codes.

For example, the SCL decoder has $L$ estimation candidates $\left(\hat{u}_0^{(\ell)}, ..., \hat{u}_{N-1}^{(\ell)}\right)$ for $\ell = 0, 1, ..., L$ - **1** after the final decoding. Since each estimation candidate includes a codeword of the concatenated CRC code, the receiver may determine validity of each estimation candidate by decoding the CRC code. An order of the estimation candidates to perform decoding of the CRC code may be determined based on the PM. The CRC code, which is a concatenated outer code, may extend the minimum distance of all codewords and may improve performance of ML-like decoding, such as maximum likelihood (ML) decoding or the SCL decoding, and the like.

Among various outer concatenation codes, a parity-check (PC) code is generally used to lead each path to a valid path in the middle of the SCL decoding. For example, in a 3GPP NR uplink polar code system, a PC code that generates 3 bit parity check bits may be used to process an information vector of 12 bits or more and 19 bits or less. The parity check bits may be referred to as PC bits or parity bits of the PC code. For example, the information bits may be transferred to a channel coding block. The information bits may be indicated as $c_{r0}, c_{r1}, c_{r2}, c_{r3}, ..., c_{r(K_r-1)}$. Herein, r is a code block number and $K_r$ is a bit of the code block number r. A total number of code blocks is indicated by r, and each code block may be individually encoded. According to a 3GPP standard, in a case of $18 \le K_r \le 25$, the number of bits $n_{PC}$ of the PC bits may be 3. Since the CRC bit is 6 bits, the number of bits of the information bits may be greater than 12 and less than 19.

Unlike the CRC code, each of the parity bits (i.e., parity check bits) of the PC code is generally used individually. For example, consider a case where the SCL decoder performs decoding on the parity bit disposed at the $i$-th. In this case, the SCL decoder has $L$ paths (e.g., $\left(\hat{u}_0^{(\ell)}, ..., \hat{u}_{i-1}^{(\ell)}\right)$), for $\ell = 0, 1, ..., L$ - 1. For the path $\ell$, an estimation $\hat{u}_i^{(\ell)}$ may be determined as illustrated in the following Equation 6 based on the Equation 1, which is the corresponding parity-check equation.

【Equation 6】

$$\hat{u}_i^{(\ell)} = \sum_{k=0}^{i-1} h_k^{(i)} \hat{u}_k^{(\ell)}$$

$\hat{u}_i^{(\ell)}$ generated by the parity-check equation is valid in terms of the PC code to be used. Thus, the use of parity bits of the PC code necessarily leads to selection of paths including a valid estimation for the $i$-th bit $u_i$.

For example, in a case of estimating $u_i$ based on the LLR, the PM, and the like, through causal generation, errors that may occur may not occur. Therefore, the estimation of the parity bits illustrated in the Equation 6 may be seen as error correction.

On the other hand, in documents [5], [6], and the like, a method of using the parity bits of the PC code as the error detection has been presented. The method of using the parity bits of the PC code as the error detection is closely related to the embodiments of the present disclosure, and will be described in more detail below.

Now, various transmission scenarios between transceivers using or set to use the polar code will be described.

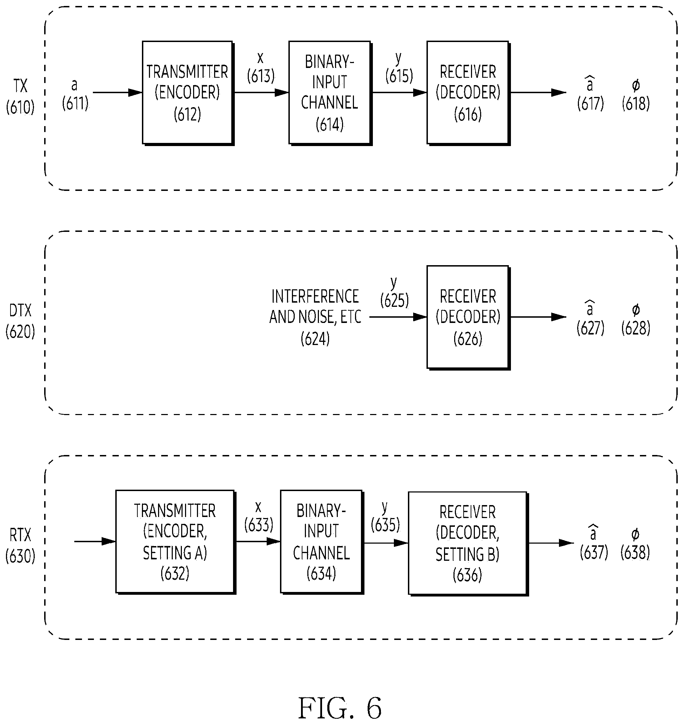

FIG. 6 illustrates examples of a transmission scenario between a transmitter and a receiver. In FIG. 6, examples of a communication system and a broadcasting system including a transmitter and a receiver set to use or use a polar code are described.

Referring to FIG. 6, first, a scenario 610 of FIG. 6 illustrates a case in which the transmitter and the receiver have the same setting, and the transmitter transmits intended information. In a case of transmitting such intended information, the scenario 610 may be simply referred to as transmission (TX).

A transmitter 612 may generate a codeword vector **x** 613 by performing encoding (e.g., the method of FIG. 3) of the polar code on an information vector 611 to be transmitted to the receiver. The codeword vector **x** 613 is transmitted through a binary-input channel 614 based on the method described in FIG. 4. The binary-input channel 614 may be an equivalent model including not only an operation of a physical channel, but also an intermediate operation such as rate matching, interleaving, scrambling, modulation, and the like performed by the transmitter 612 or a receiver 616 and a reverse process thereof. The receiver 616 may obtain a reception symbol vector **y** 615 from the binary-input channel 614 and perform decoding of the polar code on the reception symbol vector **y** 615. As a result of the decoding, the receiver 616 may output an estimation **â** 617 for the information vector **a** 611 and a report variable φ 618 for the decoding result. In the TX situation, a goal of the receiver 616 is to accurately estimate the information vector **a** 611 transmitted by the transmitter to generate **â** 617, and to output the report variable φ 618 indicating that normal decoding has taken place.

Second, a scenario 620 of FIG. 6 indicates a case in which a transmitter does not transmit a signal for any reason but a receiver 626 decodes a reception component including background noise and interference, by considering it as the signal transmitted from the transmitter. The scenario 620 may be simply referred to as discrete transmission (DTX).

The receiver 626 may regard the reception component including background noise and interference 624 as a reception symbol vector **y** 625. For example, the receiver 626 may recognize that the reception symbol vector **y** 625 is not a normally received signal through a series of operations, and may discard it and skip a subsequent operation. Conversely, for example, the receiver 626 may misunderstand the reception symbol vector **y** 625 as the normally received signal through a series of operations and attempt to decode it. The receiver 626 that has performed the decoding may output an estimation **â** 627 and a report variable φ 628 for a decoding result. In the DTX situation, the receiver 626 should output the report variable φ 628 indicating that the estimation **â** 627, which is the decoding result, is invalid.

For example, the DTX situation may include a situation in which a terminal fails to receive uplink resource allocation (e.g., UL grant) transmitted by a base station through a downlink channel, and the like, in a mobile communication system. Like the situation, the terminal fails to receive and decode uplink resource allocation information does not transmit any signal to the base station. Meanwhile, the base station may determine that the terminal normally receives the uplink resource allocation information and that the terminal transmits the uplink signal. The base station may perform a series of operations by determining the reception component including the background noise and/or the interference as the signal received from the terminal.

Third, a scenario 630 of FIG. 6 illustrates a case in which a transmitter 632 and a receiver 636 have different settings (a code parameter, a scheduling parameter, and the like) for some reason. The scenario 630 like this may be simply referred to as random transmission (RTX).

The transmitter 632 may include an encoder. The transmitter 632 may generate **x** 633 based on a setting (e.g., a setting A) such as a given code parameter and scheduling parameter, and the like. The transmitter 632 transmits **x** 633 through a binary-input channel 634. **x** 633 is generated based on a setting different from a setting (e.g., a setting B) of the receiver 636. For example, **x** 633 may not be a codeword vector generated by a polar code. It may be a codeword vector generated by another channel code, or may not be a codeword vector of any channel code. That is, **x** 633 may be a random bit vector or sequence when viewed from the setting (e.g., the setting B) of the receiver 636. The binary-input channel 634 to which the x633 is transmitted may be an equivalent model including not only an operation of a physical channel, but also an intermediate operation such as rate matching, interleaving, scrambling, modulation, and the like performed by the transmitter 623 or the receiver 636 and a reverse process thereof. The receiver 636 may include a decoder. The receiver 636 may obtain a reception symbol vector **y** 635 from the binary-input channel 634. The receiver 636 may perform decoding of the polar code on the reception symbol vector **y** 635 based on the given setting (e.g., the setting B). As a result of this, the receiver 636 may output an estimation **â** 637 for an information vector and a report variable φ 638 for a decoding result. In the RTX situation, the receiver 636 should output the report variable φ 638 indicating that the estimation **â** 637, which is the decoding result, is invalid.

The RTX situation may include, as an example, a blind detection operation performed by a terminal in the mobile communication system. For example, in a 3GPP NR downlink control channel (e.g., PDCCH), a base station may encode an information bit in a polar code with an arbitrary setting and transmit it to the terminal. The terminal does not know exactly how the reception signal is encoded and scheduled, and only knows about a set of possible codes and scheduling combinations. Therefore, the terminal attempts to demodulate, restore, and decode the signal using each combination set of all possible combination sets. Therefore, a case in which a setting (e.g., the setting A) considered by the terminal and a setting (e.g., the setting B) actually considered by the base station are different may be considered as an example of the RTX situation.

As another example, the RTX situation may include a situation in which the terminal normally receives and decodes uplink resource allocation information (e.g., DCI format 1_0, DCI format 1_1, or DCI format 1_2) transmitted through the downlink control channel (e.g., PDCCH) in mobile communication, but the terminal misses a signal transmitted through a downlink data channel (e.g., PDSCH). The base station expects the terminal to multiplex ACK/NACK, which is a result of decoding data (e.g., PUSCH) and receiving data (e.g., PDSCH) allocated by the uplink resource allocation information, and transmit it through a physical uplink shared channel (PUSCH). However, since the terminal missed the signal transmitted through the downlink data channel, it does not multiplex ACK/NACK and transmits only the data set by the uplink resource allocation information through the PUSCH. On the other hand, the base station may attempt to decode the received signal through demultiplexing, assuming that the received PUSCH signal and ACK/NACK are multiplexed. Since such a signal is a random signal that is statistically completely different from what the base station expects, the situation may be regarded as the RTX situation.

The receiver should accurately determine various situations and scenarios (e.g., the scenario 610, the scenario 620, and the scenario 630) including TX, DTX, and RTX, and perform a follow-up operation suitable for the determined situation.

The receiver misjudging invalid results, such as DTS, RTX and the like, as being valid should be avoided because it causes a serial and fatal error between the transceivers later. As such, the error in which the receiver determines that an abnormal result such as DTX and RTX is valid may be referred to as a false alarm (FA) or a false positive (FP). In addition, a rate at which these errors occur may be referred to as a FA rate (FAR) or a FP rate (FPR). FAR may be used as a performance metric for detecting an abnormal situation such as DTX and RTX, and it means a detection technique is superior as a value of it is smaller. The receiver may use various techniques to lower the FAR.

On the other hand, as the receiver applies the technique to lower FAR, it should avoid a situation of misjudging and discarding the valid result decoded in the TX situation as invalid. The error determining that the valid result is not valid may be referred to as a miss, a false negative (FN), and the like. In addition, a rate at which these errors occur may be referred to as a miss rate (MR), a FN rate (FNR), and the like.

FAR and MR have a characteristic of antinomy. When applying a rule, a policy, and a technique to lower FAR, it may be determined that more transmission situations are not valid, thereby increasing the rate of determining a valid situation as invalid and increasing MR. As an extreme example, when all transmission situations are judged to be invalid, FAR is 0, but MR is 1. This is the same in an opposite case. Therefore, multiple studies have been conducted to achieve an appropriate tradeoff between FAR and MR. For example, a hard decision-based method using outer coding (e.g., the document [5], and [6]) and a soft decision-based method using a soft metric (e.g., the document [6],and [7]) were presented. The techniques of the two categories may be used separately or simultaneously.

Embodiments of the present disclosure relate to a hard decision-based validity determination method using the outer coding. In the embodiments of the present disclosure, the invalid transmission situation such as DTX and RTX may be effectively detected or determined by appropriately and effectively using the outer coding used by being concatenated according to an embodiment. The embodiments of the present disclosure may include operations in a case that a CRC code and a PC code are used together, such as a 3GPP NR uplink system.

Parity bits included in the configuration of the polar code may be classified into the following three types according to a generation method and how they are used in a decoding process.

1) CRC bits: Parity bits in this category are not necessarily generated by CRC codes, but a feature is represented by CRC codes and are usually called this. The CRC bits are used to determine validity of the finally obtained estimation(s) after decoding, such as SC decoding and SCL decoding. In a case that there are a plurality of estimation candidates, decoding of the CRC codes may be performed for all candidates, or may be performed only for some candidates. In a case that the decoding of the CRC codes for all or part of the candidates fails, the decoder may declare a decoding failure and discard the result. These CRC bits are not usually used individually, but are comprehensively used in decoding for an outer codeword vector unit after the decoding. For example, the outer codeword vector **b** including the CRC bits may be processed collectively by a decoder of the CRC codes composed of a linear feedback shift register (LFSR). Since the CRC bits are not utilized in the middle of sequential decoding, they need not necessarily be causally generated on the encoder input vector **u**. In the 3GPP NR polar code system, CRC bits of 6 bits are used when transmitting control information (e.g., uplink control information (UCI)) of 12 bits or more and 19 bits or less of uplink. In addition, in the 3GPP NR polar code system, CRC bits of 11 bits are used when transmitting control information greater than 20 bits of uplink.

2) Error-correction parity-check bit (EC-PC bit): Parity bits in this category are parity bits causally generated on the encoding input vector **u**. Consider a case where an SCL decoder performs decoding using a parity bit disposed at the $i$-th as an EC-PC bit. The SCL decoder has $L$ paths $\left( \hat{u}_0^{(\ell)}, ..., \hat{u}_{i-1}^{(\ell)} \right)$ for $\ell = 0, 1, ..., L - 1$. The decoder determines an estimated value $\hat{u}_i^{(\ell)}$ for each path $\ell$ according to the parity-check equation $\hat{u}_i^{(\ell)} = \sum_{k=0}^{i-1} h_k^{(i)} \hat{u}_k^{(\ell)}$ of the Equation 6. This estimation is always a valid result in terms of applied outer coding. An effect of the SC decoding and SCL decoding operation on the EC-PC bit may be interpreted in various ways. First, under a premise that an estimation for the preceding bits is correct, the parity-check equation prevents an error (an invalid estimation in terms of the outer encoding) that may occur when estimating the parity bit based on PM, LLR, and the like. Additionally, in case the estimation of the preceding bits of certain paths is incorrect, the parity-check equation has an effect of leading the decoding to proceed in the right direction by penalizing a PM value for invalid paths. In this respect, the operation for the EC-PC bit (i.e., the operation of determining the estimation value through the parity-check equation) may be interpreted as an error correction operation. In a case of encoding control information of 12 bits or more and 19 bits or less in the 3GPP NR uplink polar code system, the parity bits of 3 bits are generated by the PC code, and these bits were standardized in consideration of being used as the EC-PC bit.

3) Error-detection parity-check bit (ED-PC bit): Parity bits in this category are also causally generated parity bits on the encoder input vector **u**. Consider a case in which the SCL decoder performs decoding using a parity bit disposed at the $i$-th as an ED-PC bit. The SCL decoder has $L$ path $\left(\hat{u}_0^{(\ell)}, \ldots, \hat{u}_{i-1}^{(\ell)}\right)$ for $\ell = 0, 1, \ldots, L - 1$. The decoder calculates PM for $\left(\hat{u}_0^{(\ell)}, \ldots, \hat{u}_{i-1}^{(\ell)}, 0\right)$ and $\left(\hat{u}_0^{(\ell)}, \ldots, \hat{u}_{i-1}^{(\ell)}, 1\right)$ for each path $\ell$. Since two paths to $u_i \in \{0, 1\}$ are derived from $L$ paths, a total number of candidate groups of paths to be considered at this stage is $2L$. The SCL decoder selects $L$ paths among the $2L$ path candidate groups by a predetermined method, and discards the rest. The selection of the path may be made based on LLR, PM, and the like calculated during the decoding process. Surviving paths by this process have an estimated $\hat{u}_i^{(\ell)}$. At the same time, the decoder calculates a syndrome $\acute{u}_i^{(\ell)} = \sum_{k=0}^{i-1} h_k^{(i)} \hat{u}_k^{(\ell)}$ identifying validity of the estimated bits for the $L$ surviving paths. The decoder compares the estimated bit $\hat{u}_i^{(\ell)}$ with the syndrome bit $\acute{u}_i^{(\ell)}$, and displays that a corresponding path is invalid if the two results are different. A method of displaying validity of a path may vary, and for example, a result may be displayed through a tag, which is a binary variable indicating the validity for each path. In sequential decoding, if the intermediate path or all paths are identified to be invalid, there is no longer a need to proceed with the decoding, and the decoding may be early terminated. Early termination of the decoding helps reduce average decoding complexity, power consumption, and delay. In a case of encoding control information in a 3GPP NR downlink polar code system, parity bits of 24 bits are generated by distributed CRC codes, and the parity bits were standardized in consideration of being used as ED-PC bits.

Simply summarized, the EC-PC bits and the ED-PC bits are identically generated causally on the encoder input vector **u** and are distinguished only by how they are used in the decoder. Therefore, the corresponding distinction is determined entirely by the operation of the receiver. Therefore, the parity bits of 3 bits generated by the PC codes in the 3GPP NR uplink polar code system may be used as ED-PC bits rather than EC-PC bits in the decoder. In addition, the parity bits of 24 bits generated by distributed CRC codes in the 3GPP NR downlink polar code system may be used as EC-PC bits rather than ED-PC bits.

The causally generated parity bits are collectively referred to as parity-check (PC) bits. In the receiver, each PC bit may be used as an EC-PC bit or as an ED-PC bit.

The number of CRC bits generated by outer encoding in an encoder of the transmitter is written as $J$, and the total number of PC bits generated causally is written as $D$. For example, in a case of transmitting the control information with a size 12 bits or more and 19 bits or less, two types of concatenated outer coding, CRC codes and PC codes are used. The encoder may generate the CRC bits of $J = 6$ through the CRC codes and generate the PC bits of $P = 3$ through the PC codes.

The receiver performs decoding by treating $D$ bits of the $P$ PC bits as ED-PC bits and $c$ bits as EC-PC bits. It naturally becomes $P = C + D$, and becomes $0 \leq C \leq P$ and $O \leq D \leq P$.

In the documents [5] and [6], a method of appropriately partitioning the number of paths $L_t$ decoded by the CRC codes, and the PC bits to achieve the target FAR.

When binary-summing of bits belonging to a subset of uniformly random bit vectors, a probability that its result is 0 is 1/2. Similarly, a probability that its result is 1 is also 1/2. By extending this, a probability that an arbitrary bit vector, which is not a valid outer codework vector, generated uniformly randomly, satisfies a constraint by $J$ CRC bits is given as $2^{-J}$. In case of the SCL decoding fails, the $L$ paths finally given by error propagation of sequential decoding are based on a uniformly random sequence. When SCL decoding fails, FAR, which is a probability that all $L$ uniformly random paths satisfy the constraints of $J$ CRC bits, and a false alarm (FA) occurs, is written as $\rho(J,L)$. This value may be approximated as illustrated in Equation 7 below.

【Equation 7】

$$\rho(J,L) = 1 - \left(1 - 2^{-J}\right)^L$$

The fact that may be confirmed from the Equation 7 is that the number of constraints $J$ should be increased or the number of paths $L$ to be tested should be reduced, in order to lower the FAR.

One of methods of reducing a value corresponding to the number of paths $L$ in the Equation 7 is to directly reduce the list size $L$ of the SCL decoding. Since performance of the SCL decoding varies greatly according to the list size, reducing the list size *L* may significantly lower error correction performance. Another method is to keep the list size of the SCL decoding as *L,* but limit the number of paths to perform the decoding of the CRC codes to $L_t$ after the decoding is terminated. In the middle of the SCL decoding, the sufficiently large list size *L* can be used to increase the performance of path search, and the performance loss may be reduced by limiting only the list size to $L_t$ for determining validity after the decoding is terminated. A path for determining the validity after the decoding is terminated may be selected based on LLR, PM, and the like. The $L_t$ is referred to as the number of CRC trials and is determined within a range of $1 \le L_t \le L$. In this case, the FAR may be written as illustrated in Equation 8 below.

【Equation 8】

$$\rho(J, L_t) = 1 - \left(1 - 2^{-J}\right)^{L_t}$$

One of the methods of increasing the value corresponding to the number of constraints *J* used in the test in the Equation 7 or the Equation 8 is to perform decoding using all or portion of the PC bits as the ED-PC bits. In this case, the number of constraints verifying the validity of the path becomes *J + D*. Herein, *D* is the number of the ED-PC bits. Naturally, the FAR may be calculated as illustrated in Equation 9 below.

【Equation 9】

$$\rho(J + D, L_t) = 1 - \left(1 - 2^{-(J+D)}\right)^{L_t}$$

The documents [5] and [6] present how to find the optimal combination of $L_t$ and *D* to achieve the target FAR. When the target FAR is written as $\rho^*$, the FAR $\rho(J + D, L_t)$ given by the Equation 9 should be less than (less than or equal to) $\rho^*$. The combination of $L_t$ and *D* to achieve the target FAR may be variously determined, but the error correction performance and a miss rate (MR) due to each combination may be different. Accordingly, in the documents [5] and [6], a trade-off between better error correction performance and FAR was achieved by determining *D* as large as possible within the range of achieving the target FAR $\rho^*$, and then determining the value of $L_t$.
For example, consider a case where the number of CRC bits is *J = 6* and the number of PC bits is *P = 3* in the 3GPP NR uplink system. The number of bits of the code block may be 18 or more and 25 or less. In other words, the number of bits of information bits may be 12 or more and 19 or less. In addition, assume that the list size of the SCL decoding is *L = 8*. In case that the target FAR is given as 1%, the combination of ($L_t$, *D*) that achieves a relatively tight may be given as illustrated in Table 1. Herein, a reason for achieving the target FAR is to minimize damage to the error correction performance that may occur in reverse in a case that the FA is achieved excessively lower than the target.

[Table 1]

| $L_t$ | D | $\rho(J + D, L_t)$ |
|---|---|---|
| 1 | 1 | 0.78% |
| 2 | 2 | 0.78% |
| 4 | 3 | 0.78% |

[An example of the combination ($L_t$, *D*) to achieve the target FAR of 1%]

Various ($L_t$, *D*) combinations to achieve the target FAR may exist as illustrated in the Table 1. Among the combinations that equally achieve the target FAR, the receiver may select a combination having the value of *D* as the maximum. This is to achieve superior performance of the SCL decoding by maintaining the largest list size until the decoding is terminated. According to the strategy, in the Table 1, a combination of $L_t = 4$ and *D = 3* may be selected to achieve an expected FAR of 0.78% lower than the target FAR of 1%.
The receiver may determine a position of a PC bit to be used as an ED-PC bit and an EC-PC bit, respectively, among the PC bits. Specifically, among the *P* PC bits, the receiver may determine which position of the PC bits to use as the ED-PC bit and which position of the PC bits to use as the EC-PC bit according to a specific method and rule. In other words, the receiver may use the specific method and rule for partitioning the given PC bits into the ED-PC bit and the EC-PC bit. For example, the receiver may select the *D* PC bits with high or low index on the encoder input vector **u** among the

$\mathscr{B}$ PC bits as the ED-PC bits, and may use remaining bits as the EC-PC bits. For another example, the receiver may select the $D$ PC bits with a high or low metric for performance evaluation on the encoder input vector **u** among the $\mathscr{B}$ PC bits as the ED-PC bits, and may use remaining bits as the EC-PC bits.

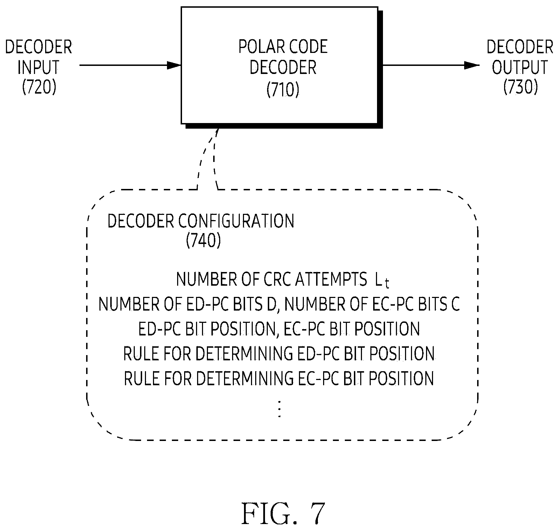

FIG. 7 illustrates a configuration of a polar code decoder including a function of decoding and determining validity of a decoding result. In FIG. 7, a configuration of a polar code decoder 710 including the function of determining the decoding and the validity of the decoding result is described.

Referring to FIG. 7, the polar code decoder 710 may receive a decoder input 720 and process the received decoder input 720. The decoder 710 may obtain a decoder output 730. The decoder input 720 may include at least one of a reception symbol, a demodulation result, and an LLR vector. The decoder output 730 may include at least one of an estimation bit sequence or a validity determination report. The polar code decoder 710 may be set to at least one decoder configuration value 740. The decoder configuration 740 may include at least one of the number of CRC attempts $L_t$ to be used by an SCL decoder, the number of ED-PC bits $D$, the number of EC-PC bits $c$, a metric or a rule for determining a position/index or a position/index of the ED-PC bits, and a metric or a rule for determining a position/index or a position/index of the EC-PC bits. At least some of the configuration values of the decoder configuration 740 may be fixed without being separately inputted or set, by being embedded in the polar code decoder 710 itself.

In the present disclosure, a technique for identifying dummy PC bits that may potentially occur due to the configuration of the polar code and finding an optimal $L_t$ and $D$ combination based on the identified dummy PC bits is described.

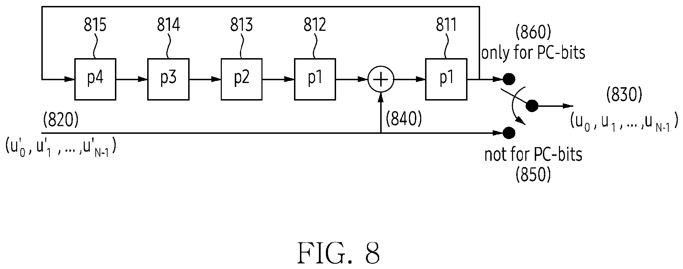

FIG. 8 illustrates an example of a process of generating a PC bit using a circular shift register. In a concatenated polar code system, the PC bit may be generated by various methods.

Referring to FIG. 8, for example, in a 3GPP NR polar code system, a PC bit is generated using a circular shift register of length 5. Specifically, in this system, a value of the PC bit is not generated by a separate outer encoding, but is generated during a subchannel allocation process. Hereinafter, a process of generating the PC bit in the 3GPP NR polar code system will be described.

1) Register $p_0, p_1, p_2, p_3, p_4$ 811 ~ 815 of length 5 is set. A value of each register is initialized to 0.

2) A temporary encoder input vector $\mathbf{u}' = \left( u'_0, u'_1, ..., u'_{N-1} \right)$ 820 is generated. The temporary encoder input vector **u'** is a vector mapped according to a given subchannel allocation rule to which an information bit and a CRC bit of an outer codeword vector **b**. As a result, the temporary encoder input vector **u'** is a vector in which a value thereof is 0 as only PC bits have not yet been determined in an encoder input vector **u** 830.

3) Set a bit index $i$ to 0.

4) The circular shift register operates one time as follows.

【Equation 10】

$$p' \leftarrow p_0, \quad p_0 \leftarrow p_1, \quad p_1 \leftarrow p_2, \quad p_2 \leftarrow p_3, \quad p_3 \leftarrow p_4, \quad p_4 \leftarrow p'$$

5) The 0th value $p_0$ 811 of the circular shift register is updated to $p_0 \leftarrow p_0 + u'_i$ by adding a temporary encoding input bit $u'_i$ 840. Herein, the addition is a binary-sum. If $u_i$ is a frozen bit or a PC bit, the register $p_0$ is the same as not being updated.

6) In a case that $u_i$ is assigned for a bit of a type other than the PC bit, $u_i$ is updated to $u'_i$ 850. In a case that $u_i$ is assigned for the PC bit, $u_i$ is updated to $p_0$ 860.

Since the generation of the PC bit using the circular shift register as described above is implemented by a consistent operation, it is easy to implement as hardware.

However, in a case of generating the PC bit by the above operation, it may not be guaranteed that each PC bit is generated by a linear combination of preceding bits. In other words, $u_i$ is allocated as the PC bit, but no preceding bit affects $u_i$, as a result, its value may be a frozen bit, which is a fixed value (e.g., an initial value 0). A bit allocated as the PC bit, but whose value is fixed irrespective of any other bit, may be referred to as a dummy PC bit.

The dummy PC bit may be generated according to a code parameter and configuration. In particular, the PC bit allocated to a low index on the encoder input vector **u** is highly likely to be the dummy PC bit.

The dummy PC bit may be used as an ED-PC bit in a sequential decoding process of the polar code. In the ED-PC bit, a relationship between values of the preceding bits and the PC bit is verified by a given parity-check equation. However, if the PC bit is not related to any preceding bits, no parity-check equation is established to verify. Therefore, the dummy PC bit may not function as the ED-PC bit that performs error detection on the preceding bits.

On the other hand, the dummy PC bit may operate as an EC-PC bit. In a case that the dummy PC bit is the ED-PC than a case that there is no dummy PC bit, functionality such as performance may be lower, but the dummy PC bit may still operate as the EC-PC bit. A role of the EC-PC bit in an SCL decoder is to extend paths to be estimated to a valid path. Although the dummy PC bit(s) are not related to the preceding bits, since their value is deterministic, there is no problem in identifying the valid path.

A receiver and a decoder according to embodiments of the present disclosure are characterized in that the dummy PC bit is used as the EC-PC bit without setting the dummy PC bit as the ED-PC bit. Among the given PC bits, $P_d$ indicates the number of dummy PC bits. In addition, PC bits other than dummy PC bits may be referred to as normal PC bits. The number of bits of the normal PC bits may be $P_n = P - P_d$.

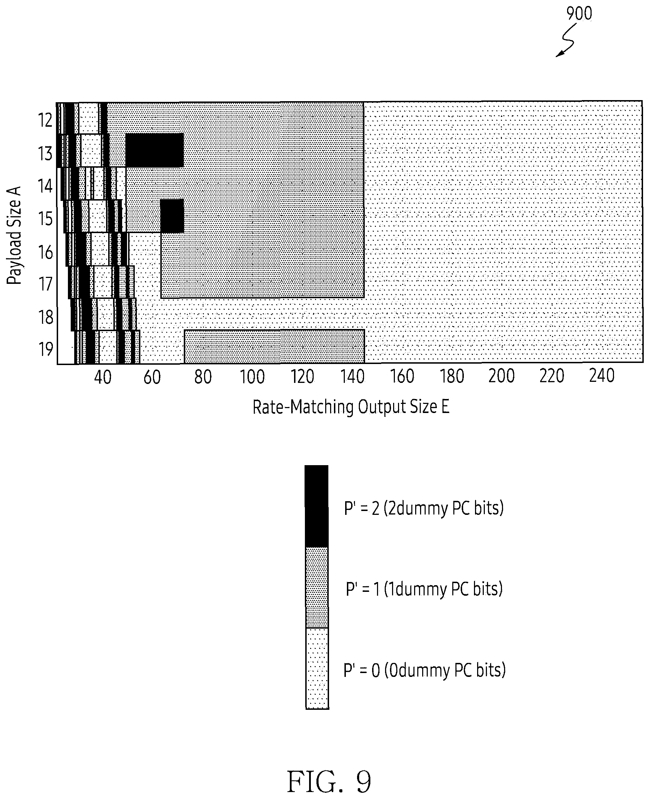

FIG. 9 illustrates the number of dummy parity check (PC) bits in a 3rd generation partnership project (3GPP) new radio (NR) uplink polar code system. For example, information bits may be transferred to a channel coding block. The information bits may be displayed by $c_{r0}, c_{r1}, c_{r2}, c_{r3}, ... , c_{r(K_T-1)}$. Herein, r is a code block number and ⬛ is the number of bits of the code block number r. A total number of code blocks is displayed by r, and each code block may be individually encoded. According to a 3GPP standard, in a case of ⬛ $18 \le K_r \le 25$, the number of bits $n_{PC}$ of PC bits may be 3. Since CRC bits are 6 bits, the number of bits of the information bits may be greater than 12 and less than 19.

Referring to FIG. 9, a graph 900 indicates how many dummy PC bits are generated in a 3GPP NR uplink system according to the number of bits $A$ of control information (e.g., UCI) and a rate matching output length $E$ (the number of bits transmitted through an actual channel after the matching, such as puncturing, shortening, repetition, and the like). The number of the information bits for the control information, that is, a range of $A$, is $A \in \{12,13,14,15,16,17,18,19\}$, and the graph 900 may include all cases of using a PC code (e.g., the number of PC bits $n_{pc}$ is 3) in a 3GPP NR polar code system. In addition, the rate matching output length $E$ has identified all cases that may be defined for the number of bits $A$ of the given control information in the 3GPP NR polar code system. In the graph 900, the rate matching output length $E$ may be configured in units of 1-bit up to 260 bits. According to a combination of the number of bits $A$ and the rate matching output length $E$ of each control information, a polar code is formed in the code configuration method described in the document [3].

According to the configuration of the polar code, up to two dummy PC bits may be generated among the total three PC bits. In particular, for the number of bits $A$ of each control information, in a case that the rate matching output length $E$ is short, it may identify that more dummy PC bits tend to occur.

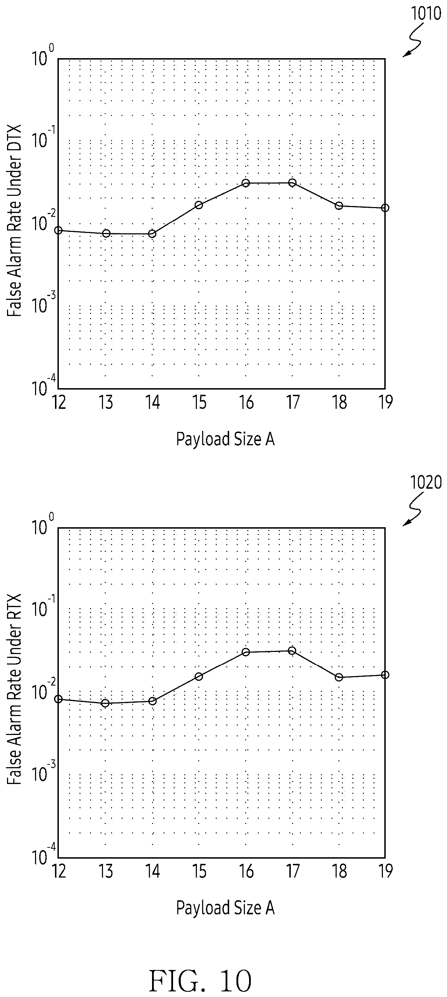

FIG. 10 illustrates a false alarm rate (FAR) according to a payload size. A situation that a rate matching output length is $E = (A + J) \times 2$ since the number of bits of control information (e.g., UCI) is $A \in \{12,13,14,15,16,17,18,19\}$ and a code rate of a polar code is 1/2, in the 3GPP NR uplink polar code system, is assumed.

Referring to FIG. 10, a graph 1010 indicates FAR for each payload size in a DTX scenario. A graph 1020 indicates FAR for each payload size in an RTX scenario 1020. $J$ considered when determining a rate matching output length is the number of bits of CRC bits, for example, $J$ is 6. The number of dummy PC bits $P_d$ generated according to the number of bits of control information in the configuration is indicated as illustrated in Table 2.

[Table 2]

| $A$ | 12 | 13 | 14 | 15 | 16 | 17 | 18 | 19 |
|---|---|---|---|---|---|---|---|---|
| $P_d$ | 0 | 0 | 0 | 1 | 2 | 2 | 1 | 1 |

The number of dummy PC bits in a polar code of a code rate 1/2

A target FAR $\rho^*$ is 1%, and a decoder selected a combination of the number of CRC attempts $L_t = 4$ and the number of ED-PC bits $D = 3$ among the combinations in Table 1 to achieve this. All of the $P = 3$ PC bits given according to this setting may be used as ED-PC bits. If an occurrence of the dummy PC bit is not considered, an expected FAR is given as 0.78% according to the Equation 9.

In a case that the number of bits $A$ of the control information is 12, 13, and 14 bits, a lower FAR than the target FAR $\rho^* = 1\%$ is achieved in both the graph 1010 for the DTX scenario and the graph 1020 for the RTX scenario. The FAR value is close to the expected FAR of 0.78%. In a case that the number of bits $A$ of the control information is 15, 16, 17, 18, and 19 bits, the target FAR $\rho^* = 1\%$ may not be achieved in both the graph 1010 for the DTX scenario and the graph 1020 for the RTX scenario.

According to embodiments of the present disclosure, in order to lower the FAR, the decoder of the polar code may be set based on the number of bits $P_d$ of the dummy PC bits and a position or an index of the dummy PC bits. In other words, according to embodiments of the present disclosure, the decoder of the polar code may be set based on the number of normal PC bits $P_n$ and a position or an index of the corresponding bits, not the dummy PC bits.

For example, the number of bits of the normal PC bits are given by $P_n = P - P_d$, and its position or index may be confirmed by a code configuration. As discussed above, since the dummy PC bits may not be used as ED-PC bits, the number of ED-PC bits $D$ may be determined in a range of $O \leq D \leq P_n$. Among the $P_n$ normal PC bits, the $D$ determined in the range may be used for the ED-PC bits by being determined by a specific rule or method. Additionally, the $C = P - D$ remaining PC bits may be used as EC-PC bits. According to the determined number of ED-PC bits $D$ and the number of EC-PC bits $C$, the number of CRC attempts $L_t$ may be determined.

For example, consider the decoder of the polar code in which the number of CRC bits is $J = 6$, the number of PC bits is $P = 3$, and the list size is $L = 8$. The purpose of a setting of the decoder of the polar code is to achieve a lower FAR than the target FAR $\rho^* = 1\%$.

If the number of dummy PC bits is $P_d = 0$ bits and the number of normal PC bits is $P_n = 3$ by the code configuration, the number of ED-PC bits $D$ may be set to 1, 2, or 3 under the range $0 \leq D \leq P_n$ with reference to the Table 1. The receiver may determine the number of CRC attempts $L_t$ based on the number of ED-PC bits. For example, in a case that the number of ED-PC bits is 1, 2, or 3, the receiver may set the number of CRC attempts $L_t$ to 1, 2, or 4, respectively.

If the number of dummy PC bits is $P_d = 1$ bits and the number of normal PC bits is $P_n = 2$ by the code configuration, the number of ED-PC bits $D$ may be set to 1 or 2 under the range $0 \leq D \leq Pn$ with reference to the Table 1. The receiver may determine the number of CRC attempts $L_t$ based on the number of ED-PC bits. For example, in a case that the number of ED-PC bits is 1 or 2, the receiver may set the number of CRC attempts $L_t$ to 1 or 2, respectively.

If the number of dummy PC bits is $P_d = 2$ bits and the number of normal PC bits is $P_n = 1$ by the code configuration, the number of ED-PC bits $D$ may be set to 1 under the range of $0 \leq D \leq P_n$ with reference to the Table 1. The receiver may determine the number of CRC attempts $L_t$ based on the number of ED-PC bits. For example, in a case that the number of ED-PC bits is 1, the receiver may set the number of CRC attempts $L_t$ to 1, respectively.

In order to satisfy the target FAR 1%, the receiver may use a policy or a rule that selects the number of ED-PC bits $D$ having the maximum value in a given range and selects the number of CRC attempts $L_t$ according to the number of selected ED-PC bits $D$. The receiver may select a combination of the number of CRC attempts $L_t$ and the number of ED-PC bits $D$ according to the number of dummy PC bits and the number of normal PC bits, as illustrated in Table 3.

[Table 3]

| $P_n (P_d)$ | $L_t$ | $D$ | $\rho(J + D,L_t)$ |
|---|---|---|---|
| 1 (2) | 1 | 1 | 0.78% |
| 2 (1) | 2 | 2 | 0.78% |
| 3 (0) | 4 | 3 | 0.78% |

[An example of the ($L_t$, $D$) combination that achieves the target FAR 1% based on the number of dummy/normal PC bits]

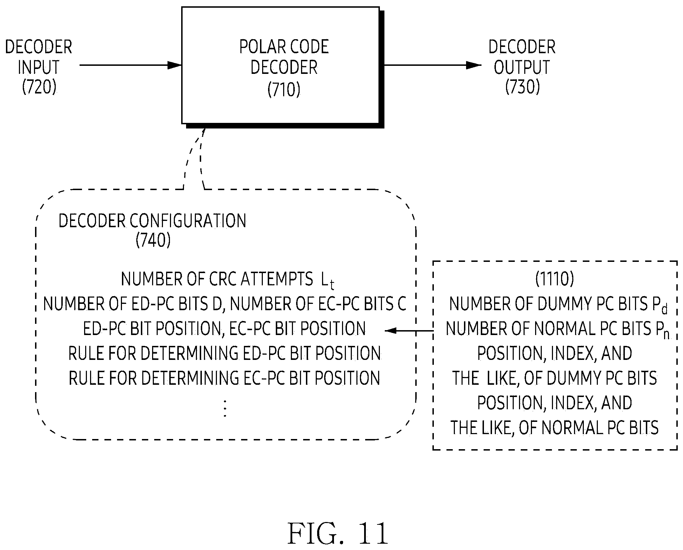

FIG. 11 illustrates an example of a configuration of a polar code decoder for decoding and determining validity of a decoding result based on a dummy PC bit. In FIG. 11, examples of utilizing dummy PC bits according to embodiments of the present disclosure are described in a method of determining a decoder configuration 740 when configuring the polar code decoder 710 of FIG. 7.

Referring to FIG. 11, the receiver may determine the decoder configuration 740 based on dummy PC bit information 1110.

The dummy PC bit information 1110 is allocated as a PC bit, but since no preceding bit affects the PC bit, the PC bit may include information on a frozen bit (i.e., dummy PC bit) having a fixed value (e.g., an initial value of 0). According to an embodiment, the dummy PC bit information 1110 may include information on the number of bits (e.g., Pd) of bit(s) corresponding to the dummy PC bits. According to an embodiment, the dummy PC bit information 1110 may include information on the number of bits (e.g., Pn) of bit(s) corresponding to non-dummy PC bits, that is, normal bits. According to an embodiment, the dummy PC bit information 1110 may include position information (or index information) of the dummy PC bits. According to an embodiment, the dummy PC bit information 1110 may include position information (or index information) of the normal PC bits. The dummy PC bit information 1110, in other words, the information on the dummy PC bits and/or the normal PC bits may include at least one of the number of bits, a position, and an index of the dummy PC bits, or the number of bits, a position, and an index of the normal PC bits.

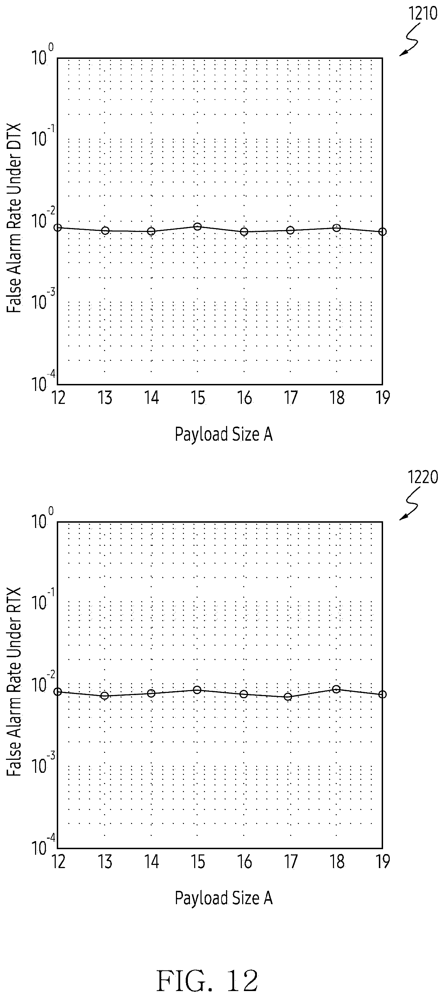

FIG. 12 illustrates an FAR according to a payload size when decoding based on a dummy PC bit. A situation that a rate matching output length is $E = (A + J) \times 2$ since the number of bits of control information (e.g., UCI) is $A \in \{12,13,14,15,16,17,18,19\}$ and a code rate of a polar code is 1/2, in the 3GPP NR uplink polar code system, is assumed. In FIG. 12, when a combination of $(L_t, D)$ is determined according to the number of dummy/normal PC bits as illustrated in the Table 3, FAR is described.

Referring to FIG. 12, a graph 1210 indicates FAR for each payload size in a DTX scenario. A graph 1220 indicates FAR for each payload size in an RTX scenario 1020. When compared with the graph 1010 and the graph 1020 of FIG. 10, it may be identified that FAR lower than a target FAR $\rho^* = 1\%$ is achieved in both cases. In the experiment of FIG. 10, the combination of $(L_t, D)$ was determined without considering the configuration of the dummy/normal PC bits, whereas in the experiment of FIG. 12, a combination of $(L_t, D)$ was determined in consideration of the configuration of the dummy/normal PC bits. From these results, it may be identified that a combination constraint using the dummy PC bits according to embodiments of the present disclosure is effective in solving a problem of reception performance and stably determining validity of a decoding result.

In a communication system and a broadcasting system of the present disclosure, based on all possible code parameters (e.g., a combination of a code dimension $A$ and the rate matching output length $E$), a receiver may identify information on dummy PC bits (or information on normal PC bits) (e.g., the number of bits of dummy PC bit(s), the number of bits of normal PC bit(s), dummy PC bits index, and normal PC bits index), and determine an optimal decoder configuration (e.g., the number of ED-PC bits $D$ and the number of CRC attempts $L_t$) based on the identified information. The optimal decoder configuration may be recorded in a storage unit such as memory and identified by being read according to the used code parameter. Alternatively, the optimal decoder configuration may be calculated or obtained based on various methods such as function call through a control unit.

For example, the receiver and a decoder may record information on the number of dummy/normal PC bits for each code parameter as illustrated in FIG. 9. In addition, as illustrated in FIG. 9, the receiver and the decoder may include a device or a method for obtaining the information on the number of dummy/normal PC bits for each code parameter. Based on this information, the receiver and the decoder may obtain or determine the optimal decoder configuration.

In another embodiment of the present disclosure, for simpler realization, the receiver may more simply determine the configuration of the decoder. For example, by dividing a range of code parameters, a decoder configuration unified within the range may be obtained or determined. For example, in FIG. 9, various dummy/normal PC bit combinations may occur when the rate matching output length $E$ is 144 bits or less, but no dummy PC bit occurs when the rate matching output length $E$ is 144 bits or less. For a simpler system configuration, if the rate matching output length $E$ exceeds 144 bits, the receiver may determine the combination of $(L_t, D)$ as (4,3). Otherwise, that is, if $E$ is 144-bit or less, the receiver may determine the combination of $(L_t, D)$ as (1,1) assuming the worst situation in which the number of bits of the dummy PC bits is two.

In some code parameter configurations, the number of dummy PC bits is less than two, resulting in excessively low FAR. Due to the excessively low FAR, loss of error correction performance may occur. However, computational complexity for setting an encoder may be reduced. In this example, the range of the code parameter is divided into two according to the rate matching output length, but more various configurations may be considered.

In addition, in another embodiment of the present disclosure, the configuration of the decoder may be determined without considering all possible code parameters in consideration of requirements or characteristics of the communication system and the broadcasting system. For example, in the 3GPP NR polar code system, control information is transmitted with a lower code rate than data information.

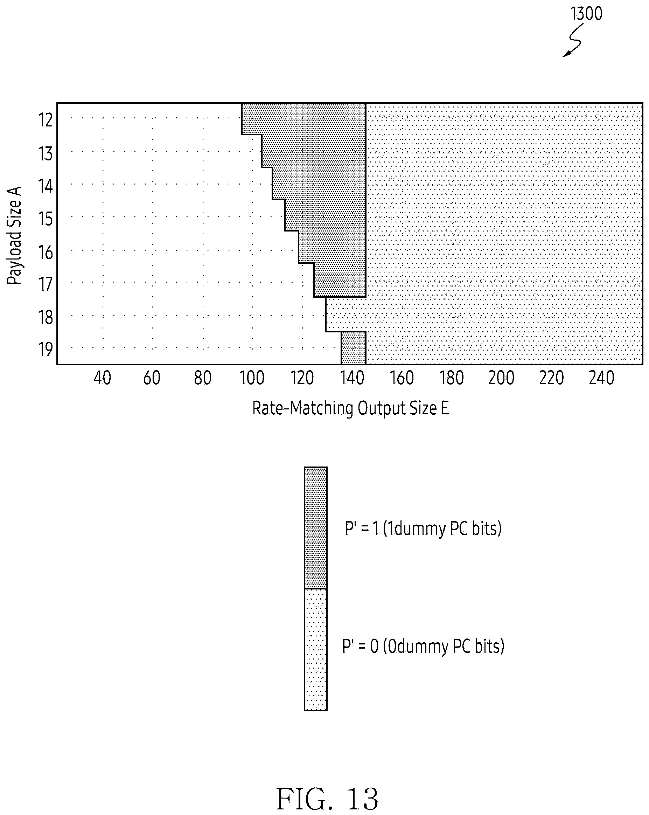

FIG. 13 illustrates the number of dummy PC bits in a 3GPP NR uplink polar code system according to a constraint of a code rate. If it is guaranteed that a code rate of control information is always lower than a specific value, a combination of valid code parameters may be limited. For example, if only a case where a code rate of a polar code is lower than 0.25 is considered, FIG. 9 may be rewritten as illustrated in FIG. 13.

Referring to FIG. 13, a graph 1300 indicates, in a situation where the code rate is lower than 0.24, the number of dummy PC bits, according to the number of bits $A$ of the control information (e.g., UCI) of the 3GPP NR uplink system, and a rate matching output length $E$. A portion without shading is an area in which a code rate is greater than or equal to 0.25. Within the limit (e.g., the code rate is lower than 0.25), a combination $(A, E)$ corresponding to the area without the shading process may not occur. The maximum number of dummy PC bit(s) that may occur within the limit is 1. Information on the dummy PC bits may be obtained or obtained more effectively. For example, a decoder may determine a configuration of the decoder according to a code parameter as illustrated in Table 4.

【Table 4】

| Code parameter | | Decoder configuration | |
|---|---|---|---|
| $A$ | $E$ | $L_t$ | $D$ |
| $A = 18$ | Any | 4 | 3 |
| $12 \leq A \leq 19$ $(A \neq 18)$ | $E \leq 144$ | 2 | 2 |
| | $E > 144$ | 4 | 3 |

In the present disclosure, operations of a transmitter related to a receiver for receiving a signal have been described. The receiver (or a decoder) for performing the above-described operations may correspond to, for example, a base station.

The above-described operations may be performed by one network entity, but embodiments of the present disclosure are not limited thereto. For example, a distributed network may be used. According to implementation, a network entity (e.g., a radio unit (RU)) that receives a signal and a network entity (e.g., a digital unit (DU) or a distributed unit (DU)) that processes a signal may be distinguished. In order to reduce a burden on the DU, a role of the RU in charge of only an existing RF function may be extended to some functions of a physical layer. As the RU performs functions of a higher layer, a throughput of the RU increases, increasing a transmission bandwidth at a fronthaul, and at the same time lowering a delay time requirement constraint due to response processing. On the other hand, as the RU performs the functions of the higher layer, a virtualization gain decreases and a size, a weight, and cost of the RU increase. In consideration of a trade-off of the above-described advantages and disadvantages, it is required to implement optimal functional separation. According to an embodiment, channel encoding or channel decoding is an operation in a baseband and may be performed at a modem end, that is, in the DU. Operations according to embodiments of the present disclosure (e.g., an operation of decoding a signal, an operation of identifying a dummy PC bit from a received signal, an operation of performing error detection, and an operation of performing error correction) may be performed by the DU. However, it does not exclude being performed by another entity (e.g., the RU).

In embodiments of the present disclosure, a method performed by a device in a communication system or a broadcasting system is provided. The method may comprise obtaining a signal. The method may comprise identifying, based on at least one information bit of the signal and a rate-matching size for a polar code, information on at least one dummy parity-check (PC) bit among at least one PC bit of the signal. The method may comprise identifying, based on the information on the at least one dummy PC bit, a decoder configuration for error detection and error correction. The method may comprise performing a decoding of the signal based on the decoder configuration. The at least one dummy PC bit may include a bit, among the at least one PC bit, that has a fixed value irrespective of one or more preceding bits of the decoding.

According to an embodiment, the information on the at least one dummy PC bit may comprise at least one of a total number of bits of the at least one dummy PC bit, a total number of bits of at least one normal PC bit, different from the at least one dummy PC bit, among the at least one PC bit, bit-position information of the at least one dummy PC bit, or bit-position information of the at least one normal PC bit.

According to an embodiment, the decoder configuration may include first information for indicating the number of cyclic redundancy check (CRC) attempts and second information for indicating the number of bits of one or more PC bits for the error detection. The number of bits of the one or more PC bits for the error detection may be configured to be less than or equal to a value obtained by subtracting the total number of bits of the at least one dummy PC bit from a total number of bits of the at least one PC bit.

According to an embodiment, the at least one dummy PC bit may be not used for the error detection and may be used for the error correction. At least one remaining bit, which is different from the one or more PC bits for the error detection among the at least one PC bit, may be used for the error correction.

According to an embodiment, the decoder configuration may comprise at least one of third information indicating the number of bits of one or more PC bits for the error correction, fourth information indicating a position of each bit of the one or more PC bits for the error detection, fifth information indicating a position of each bit of the one or more PC bits for the error correction, sixth information on a rule for determining the position of each bit of the one or more PC bits for the error detection, or seventh information on a rule for determining the position of each bit of the one or more PC bits for the error correction.

According to an embodiment, the information on the at least one dummy PC bit may be determined based on a total number of bits of the at least one information bit, the rate-matching size, and a code rate.

According to an embodiment, a total number of bits of the at least one PC bit may be three. In a case that the rate-matching size is greater than 144, the number of CRC attempts of the decoder configuration may be set to four and the number of bits of the one or more PC bits for the error detection of the decoder configuration may be set to three. In a case that the rate-matching size is less than or equal to 144, the number of CRC attempts of the decoder configuration may be set to one and the number of bits of the one or more PC bits for the error detection of the decoder configuration may be set to one.

According to an embodiment, the decoding may comprise successive cancellation (SC) decoding. The one or more preceding bits may be decoded prior to the bit having the fixed value.

According to an embodiment, the signal may include at least one frozen bit. A value of each bit of the at least one frozen bit may be 0. The fixed value may be 0.

According to an embodiment, the number of bits of the at least one information bit may be greater than or equal to 12 and less than or equal to 19. The number of bits of the at least one PC bit may be three. The signal may include uplink control information (UCI).

In embodiments of the present disclosure, a device is provided in a communication system or a broadcasting system. The device may comprise memory, at least one transceiver, and at least one processor coupled to the memory and the at least one transceiver. The at least one processor may be configured to obtain a signal. The at least one processor may be configured to identify, based on at least one information bit of the signal and a rate-matching size for a polar code, information on at least one dummy parity-check (PC) bit among at least one PC bit of the signal. The at least one processor may be configured to identify, based on the information on the at least one dummy PC bit, a decoder configuration for error detection and error correction. The at least one processor may be configured to perform a decoding of the signal based on the decoder configuration. The at least one dummy PC bit may include a bit, among the at least one PC bit, that has a fixed value irrespective of one or more preceding bits of the decoding.

According to an embodiment, the information on the at least one dummy PC bit may comprise at least one of a total number of bits of the at least one dummy PC bit, a total number of bits of at least one normal PC bit, different from the at least one dummy PC bit, among the at least one PC bit, bit-position information of the at least one dummy PC bit, or bit-position information of the at least one normal PC bit.

According to an embodiment, the decoder configuration may include first information for indicating the number of cyclic redundancy check (CRC) attempts and second information for indicating the number of bits of one or more PC bits for the error detection. The number of bits of the one or more PC bits for the error detection may be configured to be less than or equal to a value obtained by subtracting the total number of bits of the at least one dummy PC bit from a total number of bits of the at least one PC bit.

According to an embodiment, the at least one dummy PC bit may be not used for the error detection and may be used for the error correction. At least one remaining bit, which is different from the one or more PC bits for the error detection among the at least one PC bit, may be used for the error correction.

According to an embodiment, the decoder configuration may comprise at least one of third information indicating the number of bits of one or more PC bits for the error correction, fourth information indicating a position of each bit of the one or more PC bits for the error detection, fifth information indicating a position of each bit of the one or more PC bits for the error correction, sixth information on a rule for determining the position of each bit of the one or more PC bits for the error detection, or seventh information on a rule for determining the position of each bit of the one or more PC bits for the error correction.

According to an embodiment, the information on the at least one dummy PC bit may be determined based on a total number of bits of the at least one information bit, the rate-matching size, and a code rate.

According to an embodiment, a total number of bits of the at least one PC bit may be three. In a case that the rate-matching size is greater than 144, the number of CRC attempts of the decoder configuration may be set to four and the number of bits of the one or more PC bits for the error detection of the decoder configuration may be set to three. In a case that the rate-matching size is less than or equal to 144, the number of CRC attempts of the decoder configuration may be set to one and the number of bits of the one or more PC bits for the error detection of the decoder configuration may be set to one.

According to an embodiment, the decoding may comprise successive cancellation (SC) decoding. The one or more preceding bits may be decoded prior to the bit having the fixed value.

According to an embodiment, the signal may include at least one frozen bit. A value of each bit of the at least one frozen bit may be 0. The fixed value may be 0.

According to an embodiment, the number of bits of the at least one information bit may be greater than or equal to 12 and less than or equal to 19. The number of bits of the at least one PC bit may be three. The signal may include uplink control information (UCI).

According to embodiments, a device is provided in a communication system or a broadcasting system. A method of the device may comprise receiving a signal determined to be encoded based on polar codes. Herein, bits determined to be encoded may include bits assumed according to a DTX scenario, an RTX scenario, or a TX scenario. The method may comprise identifying a polar code configuration for at least one parity bit generated by at least one information bit of the signal, a frozen bit, and at least one concatenation code. The method may comprise performing a decoding the signal based on the configuration of the polar codes. The performing the decoding may comprise a process of processing the at least one parity bit by determining at least one of a first operation and a second operation. The processing of the parity bit may be performed based on at least one of information on a configuration of the parity bit, such as a code dimension, a code length, a code rate, target performance, a dummy parity bit, a normal parity bit, and the like.

According to an embodiment, the first operation on the parity bit may include determining a value of the parity bit based on at least one of preceding bits estimated by the decoding operation, or determining a value of the parity bit based on a predetermined value irrespective of the preceding bits.

According to an embodiment, the second operation on the parity bit may include a process of comparing an estimation on the parity bit with a value of an estimation on a parity bit determined by the at least one of the preceding bits.

According to embodiments of the present disclosure, a device is provided in a communication system or a broadcasting system. The device may comprise memory storing instructions, a transceiver, and a processor. The instructions, when executed by the at least one processor, may cause the device to identify, based on at least one information bit of a signal and a rate-matching size for a polar code, information on at least one dummy parity-check (PC) bit among at least one PC bit of the signal, identify, based on the information on the at least one dummy PC bit, a decoder configuration for error detection and error correction, and perform a decoding of the signal based on the decoder configuration, and the at least one dummy PC bit may include a bit, among the at least one PC bit, that has a fixed value irrespective of one or more preceding bits of the decoding.

In embodiments of the present disclosure, a non-transitory computer readable storage medium is provided. The non-transitory computer readable storage medium may store instructions, that cause, when executed by a processor of a device, the device to perform operations including obtaining a signal, identifying, based on at least one information bit of the signal and a rate-matching size for a polar code, information on at least one dummy parity-check (PC) bit among at least one PC bit of the signal, identifying, based on the information on the at least one dummy PC bit, a decoder configuration for error detection and error correction, and performing a decoding of the signal based on the decoder configuration. The at least one dummy PC bit may include a bit, among the at least one PC bit, that has a fixed value irrespective of one or more preceding bits of the decoding.

According to embodiments of the present disclosure, a method performed by a device in a communication system and a broadcasting system may comprise receiving a signal considered to be encoded based on polar codes. The method may comprise identifying a polar code configuration for at least one information bit, at least one frozen bit, and at least one parity bit generated by at least one outer code of the signal. The method may comprise decoding the signal based on the configuration of the polar codes. The decoding may include determining at least one of settings related to error detection or validity determination of the decoder, such as the number of parity bits to be used for the error detection and the number of attempts of error detection test. The decoding may be based on at least one value of information on a code configuration, such as a code dimension, a code length, a code rate, a target error detection capability, or an equivalent setting value, a dummy parity bit, and the like. The device and the method according to embodiments of the present disclosure may achieve a target level of error detection performance, validity determination rate, and error correction performance by performing decoding, error detection, and validity determination based on configuration information of at least one polar code such as the number of derby parity bits.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software including one or more instructions that are stored in a storage medium that is readable by a machine. For example, a processor of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, a compact disc-ROM (CD-ROM), an optical storage device (digital versatile discs (DVDs) or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

**Claims**

1. A device in a communication system or a broadcasting system, comprising:

    memory storing instructions;

a transceiver; and
a processor;
wherein the instructions, when executed by the processor, cause the device to:

identify, based on at least one information bit of a signal and a rate-matching size for a polar code, information on at least one dummy parity-check (PC) bit among at least one PC bit of the signal;
identify, based on the information on the at least one dummy PC bit, a decoder configuration for error detection and error correction; and
perform a decoding of the signal based on the decoder configuration; and
wherein the at least one dummy PC bit includes a bit, among the at least one PC bit, that has a fixed value irrespective of one or more preceding bits of the decoding.

2. The device of claim 1, wherein the information on the at least one dummy PC bit comprises at least one of:

a total number of bits of the at least one dummy PC bit,
a total number of bits of at least one normal PC bit, different from the at least one dummy PC bit, among the at least one PC bit,
bit-position information of the at least one dummy PC bit; or
bit-position information of the at least one normal PC bit.

3. The device of claim 1,

wherein the decoder configuration includes first information for indicating the number of cyclic redundancy check (CRC) attempts and second information for indicating the number of bits of one or more PC bits for the error detection, and
wherein the number of bits of the one or more PC bits for the error detection is configured to be less than or equal to a value obtained by subtracting the total number of bits of the at least one dummy PC bit from a total number of bits of the at least one PC bit.

4. The device of claim 3,

wherein the at least one dummy PC bit is not used for the error detection and is used for the error correction, and
wherein at least one remaining bit, which is different from the one or more PC bits for the error detection among the at least one PC bit, is used for the error correction.

5. The device of claim 3, wherein the decoder configuration comprises at least one of:

third information indicating the number of bits of one or more PC bits for the error correction;
fourth information indicating a position of each bit of the one or more PC bits for the error detection;
fifth information indicating a position of each bit of the one or more PC bits for the error correction;
sixth information on a rule for determining the position of each bit of the one or more PC bits for the error detection; or
seventh information on a rule for determining the position of each bit of the one or more PC bits for the error correction.

6. The device of claim 1,
wherein the information on the at least one dummy PC bit is determined based on a total number of bits of the at least one information bit, the rate-matching size, and a code rate.

7. The device of claim 1,

wherein a total number of bits of the at least one PC bit is three,
wherein, in a case that the rate-matching size is greater than 144, the number of CRC attempts of the decoder configuration is set to four and the number of bits of the one or more PC bits for the error detection of the decoder configuration is set to three, and
wherein, in a case that the rate-matching size is less than or equal to 144, the number of CRC attempts of the decoder configuration is set to one and the number of bits of the one or more PC bits for the error detection of the decoder configuration is set to one.

8. The device of claim 1,

   wherein the decoding comprises successive cancellation (SC) decoding, and
   wherein the one or more preceding bits are decoded prior to the bit having the fixed value.

9. The device of Claim 1,

   wherein the signal includes at least one frozen bit;
   wherein a value of each bit of the at least one frozen bit is 0; and
   wherein the fixed value is O.

10. The device of Claim 1,

    wherein the number of bits of the at least one information bit is greater than or equal to 12 and less than or equal to 19,
    wherein the number of bits of the at least one PC bit is three, and
    wherein the signal includes uplink control information (UCI).

11. A method performed by a device in a communication system or a broadcasting system, comprising:

    obtaining a signal;
    identifying, based on at least one information bit of the signal and a rate-matching size for a polar code, information on at least one dummy parity-check (PC) bit among at least one PC bit of the signal;
    identifying, based on the information on the at least one dummy PC bit, a decoder configuration for error detection and error correction; and
    performing a decoding of the signal based on the decoder configuration; and
    wherein the at least one dummy PC bit includes a bit, among the at least one PC bit, that has a fixed value irrespective of one or more preceding bits of the decoding.

12. The method of claim 11, wherein the information on the at least one dummy PC bit comprises at least one of:

    a total number of bits of the at least one dummy PC bit,
    a total number of bits of at least one normal PC bit, different from the at least one dummy PC bit, among the at least one PC bit,
    bit-position information of the at least one dummy PC bit; or
    bit-position information of the at least one normal PC bit.

13. The method of claim 11,

    wherein the decoder configuration includes first information for indicating the number of cyclic redundancy check (CRC) attempts and second information for indicating the number of bits of one or more PC bits for the error detection, and
    wherein the number of bits of the one or more PC bits for the error detection is configured to be less than or equal to a value obtained by subtracting the total number of bits of the at least one dummy PC bit from a total number of bits of the at least one PC bit.

14. The method of claim 13,

    wherein the at least one dummy PC bit is not used for the error detection and is used for the error correction, and
    wherein at least one remaining bit, which is different from the one or more PC bits for the error detection among the at least one PC bit, is used for the error correction.

15. A non-transitory computer readable storage media storing instructions, that cause, when executed by a processor of a device, the device to perform operations including:

    obtaining a signal;
    identifying, based on at least one information bit of the signal and a rate-matching size for a polar code, information on at least one dummy parity-check (PC) bit among at least one PC bit of the signal;

identifying, based on the information on the at least one dummy PC bit, a decoder configuration for error detection and error correction; and
performing a decoding of the signal based on the decoder configuration; and
wherein the at least one dummy PC bit includes a bit, among the at least one PC bit, that has a fixed value irrespective of one or more preceding bits of the decoding.

```
┌─────────────────┐                    ┌─────────────────┐
│  TRANSMITTING   │ ─────────────────▶ │   RECEIVING     │
│   END (110)     │                    │   END (120)     │
└─────────────────┘                    └─────────────────┘
```

FIG. 1

FIG. 2

a
(301) → OUTER CODING (310) → b (302) → SUBCHANNEL ALLOCATION (320) → u (303) → POLAR ENCODING (×G) (330) → x (304)

FIG. 3

x
(304) → BINARY-INPUT CHANNEL
(410) → y
(401)

FIG. 4

$$y$$
$$(401)$$ → DECODING OF POLAR CODE BY UTILIZING OUTER CODING (510) → $\hat{a}$  $\phi$
$(501)$  $(502)$

FIG. 5

**TX (610)**

a (611) → TRANSMITTER (ENCODER) (612) → x (613) → BINARY-INPUT CHANNEL (614) → y (615) → RECEIVER (DECODER) (616) → $\widehat{a}$ (617)  $\phi$ (618)

**DTX (620)**

INTERFERENCE AND NOISE, ETC (624) → y (625) → RECEIVER (DECODER) (626) → $\widehat{a}$ (627)  $\phi$ (628)

**RTX (630)**

→ TRANSMITTER (ENCODER, SETTING A) (632) → x (633) → BINARY-INPUT CHANNEL (634) → y (635) → RECEIVER (DECODER, SETTING B) (636) → $\widehat{a}$ (637)  $\phi$ (638)

FIG. 6

DECODER
INPUT
(720)

POLAR CODE
DECODER
(710)

DECODER
OUTPUT
(730)

DECODER CONFIGURATION
(740)

NUMBER OF CRC ATTEMPTS $L_t$
NUMBER OF ED-PC BITS D, NUMBER OF EC-PC BITS C
ED-PC BIT POSITION, EC-PC BIT POSITION
RULE FOR DETERMINING ED-PC BIT POSITION
RULE FOR DETERMINING EC-PC BIT POSITION
⋮

FIG. 7

FIG. 8

FIG. 9

FIG. 10

DECODER
INPUT
(720)

POLAR CODE
DECODER
(710)

DECODER
OUTPUT
(730)

DECODER CONFIGURATION
(740)

NUMBER OF CRC ATTEMPTS $L_t$
NUMBER OF ED-PC BITS D, NUMBER OF EC-PC BITS C
ED-PC BIT POSITION, EC-PC BIT POSITION
RULE FOR DETERMINING ED-PC BIT POSITION
RULE FOR DETERMINING EC-PC BIT POSITION
⋮

(1110)
NUMBER OF DUMMY PC BITS $P_d$
NUMBER OF NORMAL PC BITS $P_n$
POSITION, INDEX, AND
THE LIKE, OF DUMMY PC BITS
POSITION, INDEX, AND
THE LIKE, OF NORMAL PC BITS

FIG. 11

FIG. 12

1300

FIG. 13

## INTERNATIONAL SEARCH REPORT

| International application No. |
| --- |
| **PCT/KR2023/021953** |

| A. | CLASSIFICATION OF SUBJECT MATTER |
| --- | --- |

**H04L 1/00**(2006.01)i; **H03M 13/13**(2006.01)i; **H03M 13/00**(2006.01)i

According to International Patent Classification (IPC) or to both national classification and IPC

| B. | FIELDS SEARCHED |
| --- | --- |

Minimum documentation searched (classification system followed by classification symbols)

H04L 1/00(2006.01); H03M 13/09(2006.01); H03M 13/13(2006.01); H03M 13/35(2006.01); H04W 72/04(2009.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 극부호(polar code), 패리티 비트(parity bit), 에러 검출(error detection), 에러 정정 (error correction), 더미(dummy), 동결(frozen), 고정(fixed), 부호율 조정(rate matching), 부호율(code rate), 복호 (decoding), 설정(configuration), 순환 중복 검사(cyclic redundancy check, CRC)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JANG, Min et al. Improving the Tradeoff Between Error Correction and Detection of Concatenated Polar Codes. IEEE Transactions on Communications. Vol. 69, No. 7, 02 April 2021.<br>    See pages 4254-4261 and 4265. | 1-15 |
| Y | US 2022-0021402 A1 (TELEFONAKTIEBOLAGET LM ERICSSON (PUBL)) 20 January 2022 (2022-01-20)<br>    See paragraphs [0055], [0102]-[0103], [0108] and [0145]; and claim 32. | 1-15 |
| A | CN 110474648 A (SHANDONG UNIVERSITY OF SCIENCE AND TECHNOLOGY) 19 November 2019 (2019-11-19)<br>    See paragraph [0035]; and claims 1-4. | 1-15 |
| A | KR 10-2021-0067967 A (SAMSUNG ELECTRONICS CO., LTD.) 08 June 2021 (2021-06-08)<br>    See claims 1-7. | 1-15 |

| ✓ Further documents are listed in the continuation of Box C. | ✓ See patent family annex. |
| --- | --- |

| * Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |
| --- | --- |

| Date of the actual completion of the international search | Date of mailing of the international search report |
| --- | --- |
| **18 April 2024** | **18 April 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** |  |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2023/021953** |

**C.    DOCUMENTS CONSIDERED TO BE RELEVANT**

| Category* | Citation of document, with indication, where appropriate, of the relevant passages | Relevant to claim No. |
| --- | --- | --- |
| A | US 2019-0181980 A1 (HUAWEI TECHNOLOGIES CO., LTD.) 13 June 2019 (2019-06-13)<br>See paragraphs [0084]-[0085], [0089], [0104], [0112] and [0116]. | 1-15 |

Form PCT/ISA/210 (second sheet) (July 2022)

**INTERNATIONAL SEARCH REPORT**
Information on patent family members

International application No.

**PCT/KR2023/021953**

| Patent document cited in search report | | | Publication date (day/month/year) | Patent family member(s) | | | Publication date (day/month/year) |
|---|---|---|---|---|---|---|---|
| US | 2022-0021402 | A1 | 20 January 2022 | BR | 112019016212 | A2 | 07 April 2020 |
| | | | | CN | 110268653 | A | 20 September 2019 |
| | | | | CN | 110268653 | B | 22 March 2022 |
| | | | | EP | 3549292 | A1 | 09 October 2019 |
| | | | | EP | 3549292 | B1 | 06 April 2022 |
| | | | | ES | 2917025 | T3 | 06 July 2022 |
| | | | | JP | 2020-509660 | A | 26 March 2020 |
| | | | | JP | 7064500 | B2 | 10 May 2022 |
| | | | | US | 11165445 | B2 | 02 November 2021 |
| | | | | US | 11824561 | B2 | 21 November 2023 |
| | | | | US | 2019-0379404 | A1 | 12 December 2019 |
| | | | | US | 2024-0039560 | A1 | 01 February 2024 |
| | | | | WO | 2018-142374 | A1 | 09 August 2018 |
| CN | 110474648 | A | 19 November 2019 | | None | | |
| KR | 10-2021-0067967 | A | 08 June 2021 | CN | 115023900 | A | 06 September 2022 |
| | | | | EP | 4050805 | A1 | 31 August 2022 |
| | | | | EP | 4050805 | A4 | 04 January 2023 |
| US | 2019-0181980 | A1 | 13 June 2019 | CN | 108307527 | A | 20 July 2018 |
| | | | | CN | 108307527 | B | 04 June 2021 |
| | | | | EP | 3484126 | A1 | 15 May 2019 |
| | | | | EP | 3484126 | B1 | 06 October 2021 |
| | | | | JP | 2019-525639 | A | 05 September 2019 |
| | | | | JP | 6803969 | B2 | 23 December 2020 |
| | | | | US | 10892850 | B2 | 12 January 2021 |
| | | | | WO | 2018-028338 | A1 | 15 February 2018 |
| | | | | WO | 2018-028472 | A1 | 15 February 2018 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 11398838 B
- US 17749854 B

**Non-patent literature cited in the description**

- **E. ARIKAN**. Channel Polarization: a method for constructing capacity-achieving codes for symmetric binary-input memoryless channels. *IEEE Trans. Information Theory*, 2009, vol. 55 (7), 3051-3073
- **I. TAL** ; **A. VARDY**. List decoding of polar codes. *IEEE Trans. Inf. Theory*, 2015, vol. 61 (5), 2213-2226
- 3GPP, NR multiplexing and channel coding (Release 15). *TSG RAN TS38.212 v15.0.*, 01 February 2017
- **A. BALATSOUKAS-STIMMING** ; **M. B. PARIZI** ; **A. BURG**. LLR-based successive cancellation list decoding for polar codes. *IEEE Trans. Sig. Processing*, October 2015, vol. 19 (63), 5165-5179
- **M. JANG** ; **H. LIM** ; **H. JEONG**. *Device and method to transmit and receive signal in communication system*
- **M. JANG** ; **J. LEE** ; **S.-H. KIM** ; **K. YANG**. Improving the tradeoff between error correction and detection of concatenated polar codes. *IEEE Trans. Commun.*, July 2021, vol. 69 (7), 4254-4266
- **M. JANG** ; **H. LIM**. *Method and apparatus for decoding polar code in communication and broadcasting system*